# EUROPEAN PATENT APPLICATION

(11) **EP 4 546 422 A2**
(43) Date of publication of application: **30.04.2025**
(21) Application number: 24204584.7
(22) Date of filing: 04.10.2024
(51) Int. Cl.: H01L 25/065, H01L 25/00, H01L 23/00, H01L 23/28, H01L 23/552, H01L 23/498, H01L 23/538

(54) **MULTILEVEL SYSTEM-IN-PACKAGE MODULE WITH EMBEDDED DIE AND REDISTRIBUTION BOTTOM FEATURES**

(30) Priority: 05.10.2023 US 202363542742 P; 31.01.2024 US 202463627389 P; 27.08.2024 US 202418816392
(71) Applicant: QORVO US, INC., Greensboro, NC 27409 (US)
(72) Inventor: CARPENTER, Charles E., 27409 Greensboro (NC); MORRIS, Thomas Scott, 27409 Greensboro (NC)
(74) Representative: D Young & Co LLP

(57) **Abstract**

The present disclosure relates to a multilevel system-in-package (SIP) module having a double-sided module and a redistribution structure located underneath the double-sided module. The double-sided module includes a laminate body, a top component attached to a top surface of the laminate body, a bottom component and multiple copper posts attached to a bottom surface of the laminate body, and a bottom mold compound formed on the bottom surface of the laminate body and at least encapsulating side surfaces of the bottom component and side surfaces of each copper post. A bottom surface of the bottom mold compound is a portion of a bottom surface of the double-sided module. The redistribution structure includes a redistribution layer with multiple patterned conductive features, which are separate from each other. Each patterned conductive feature is coupled to at least one of the bottom component and the copper posts.

## Description

### Related Applications

This application claims the benefit of U.S. provisional patent application serial number 63/542,742, filed October 5, 2023, U.S. provisional patent application serial number 63/627,389, filed January 31, 2024, and U.S. patent application serial number 18/816,392, filed August 27, 2024, the disclosures of which are hereby incorporated herein by reference in their entireties.

### Field of the Disclosure

The present disclosure relates to a multilevel system-in-package (SIP) module with one or more embedded dies and redistribution bottom features, and a process of fabricating the redistribution bottom features for the SIP module.

### Background

With the popularity of portable consumer electronic products, such as smart phones, tablet computers, and so forth, double-sided modules are becoming more and more attractive in microelectronics devices to achieve electronics densification with a small footprint.

However, a system-in-package (SIP) module with a double-sided structure, which utilizes Ball Grid Array (BGA), may result in a relatively large overall thickness of the final product and have limitations for input/output (I/O) density. It is because each solder ball of the BGA has a relatively large size (in both horizontal and vertical dimensions). Alternatively, when the double-sided SIP structure utilizes Land Grid Array (LGA), the final product may have a relatively small footprint but still have limitations in input/output (I/O) locations at a bottom of the SIP module (e.g., the I/Os are only located in certain bottom areas of the SIP module with a non-uniform fine pitch). It is challenging to get enough interconnects between devices within the double-sided SIP modules and higher-level assemblies (e.g., printed circuit board, PCB), when the higher-level assemblies have a uniform and coarse connection pitch.

In addition, for the SIP modules with the double-sided structures, thermal dissipation is another challenge, especially for high frequency and high-power applications.

### Summary

Particular aspects are set out in the appended independent claims. Various optional embodiments are set out in the dependent claims.

Certain approaches described herein may be directed to accommodate lowprofile and small footprint requirements for portable products, provide enough connection and uniform I/Os for higher-level assemblies, and/or enhance thermal and electrical performance. As such an improved design of a SIP module and a process for making the same may be provided..

The present disclosure relates to a multilevel system-in-package (SIP) module with one or more embedded dies and redistribution bottom features, and a process of fabricating the redistribution bottom features for the SIP module. The disclosed multilevel SIP module includes a double-sided module and a redistribution structure located underneath a bottom surface of the double-sided module. The double-sided module includes a laminate body, at least one top component, a top mold compound, a bottom component, a number of copper posts, and a bottom mold compound. The at least one top component is attached to a top surface of the laminate body, and the top mold compound is formed on the top surface of the laminate body to encapsulate the at least one top component. The bottom component and the copper posts are attached to a bottom surface of the laminate body, while the bottom mold compound is formed on the bottom surface of the laminate body and at least encapsulates side surfaces of the bottom component and side surfaces of each of the copper posts. A top surface of the double-sided module is a top surface of the top mold compound, side surfaces of the double-sided module are a combination of side surfaces of the top mold compound, side surfaces of the laminate body, and the side surfaces of the bottom mold compound, and a bottom surface of the double-sided module is at least composed of a bottom surface of the bottom mold compound. The redistribution structure includes a redistribution layer with a number of patterned conductive features, which are separate from each other. Each of the patterned conductive features is coupled to at least one of the bottom component and the copper posts.

In one embodiment of the multilevel SIP module, the bottom component is a flip-chip die and each copper post has a same height. Herein, the bottom surface of the bottom mold compound, a backside surface of the flip-chip die, and an end surface of each copper post are coplanar and constitute the bottom surface of the double-sided module. The flip-chip die is a silicon (Si) die.

In one embodiment of the multilevel SIP module, the redistribution structure further includes a first dielectric pattern with a number of first openings. The first dielectric pattern is located directly underneath the bottom surface of the double-sided module, such that the first dielectric pattern is in contact with the backside surface of the flip-chip die, and in contact with the end surface of each copper post. The first openings are positioned so that the backside surface of the flip-chip die and the end surface of each copper post are partially exposed. The patterned conductive features fill the first openings to be coupled with the bottom component and the copper posts, respectively, and extend underneath the first dielectric pattern. The first dielectric pattern is formed from a photo-imageable dielectric (PID) layer or a non-photo-imageable build-up film.

In one embodiment of the multilevel SIP module, the redistribution structure further includes a seed layer with a number of discrete seed layer segments. The seed layer completely and directly covers exposed surfaces within each first opening and extends underneath portions of the first dielectric pattern, such that the seed layer is in contact with the backside surface of the flip-chip die, and the end surface of each copper post. Each patterned conductive feature is in direct contact with a corresponding one of the discrete seed layer segments, such that each patterned conductive feature is coupled to at least one of the bottom component and the copper posts via the corresponding one of the discrete seed layer segments.

In one embodiment of the multilevel SIP module, the redistribution structure further includes a number of extra patterned conductive features and a second dielectric pattern with a number of second openings. The second dielectric pattern is located directly underneath the first dielectric pattern to partially encapsulate each patterned conductive feature. Herein, each patterned conductive feature is partially exposed through one or more corresponding ones of the second openings of the second dielectric pattern. The extra patterned conductive features fill the plurality of second openings to be coupled with the plurality of patterned conductive features, respectively, and extend underneath the second dielectric pattern. The second dielectric pattern is formed from a PID layer or a non-photo-imageable build-up film.

In one embodiment of the multilevel SIP module, the redistribution structure further includes an extra seed layer with a number of discrete extra seed layer segments. The extra seed layer completely and directly covers exposed surfaces within each second opening and extends underneath portions of the second dielectric pattern, such that the extra seed layer is in contact with each patterned conductive feature. Each extra patterned conductive feature is in direct contact with a corresponding one of the discrete extra seed layer segments, such that the extra patterned conductive features are coupled to the patterned conductive features via corresponding ones of the discrete extra seed layer segments, respectively. The redistribution structure further includes a coating that completely covers each extra patterned conductive feature and is configured to enable each extra patterned conductive feature to have a solderable surface. Herein, the coating is formed of one of electroless nickel immersion gold (ENIG), organic solderability preservatives (OSP), Electroless Nickel Electroless Palladium Immersion Gold (ENEPIG), and solder alloy.

In one embodiment of the multilevel SIP module, the redistribution structure further includes a seed layer with a number of discrete seed layer segments. The seed layer is in contact with and partially covers the bottom surface of the double-sided module so as to be in contact with the backside surface of the flip-chip die, and the end surface of each copper post. Each of the plurality of patterned conductive features is in direct contact with a corresponding one of the discrete seed layer segments, such that each patterned conductive feature is coupled to at least one of the bottom component and the copper posts via the corresponding one of the discrete seed layer segments.

In one embodiment of the multilevel SIP module, the redistribution structure further includes a number of extra patterned conductive features and a dielectric pattern with a number of openings. The dielectric pattern is located directly underneath the bottom surface of the double-sided module to partially encapsulate each patterned conductive feature. Herein, each patterned conductive feature is partially exposed through one or more corresponding ones of the openings of the dielectric pattern. The extra patterned conductive features fill the openings to be coupled with the patterned conductive features, respectively, and extend underneath the dielectric pattern. The dielectric pattern is formed from a PID layer or a non-photo-imageable build-up film.

In one embodiment of the multilevel SIP module, the redistribution structure further includes an extra seed layer with a number of discrete extra seed layer segments. The extra seed layer completely and directly covers exposed surfaces within each opening and extends underneath portions of the dielectric pattern, such that the extra seed layer is in contact with each patterned conductive feature. Each extra patterned conductive feature is in direct contact with a corresponding one of the discrete extra seed layer segments, such that the extra patterned conductive features are coupled to the patterned conductive features via corresponding ones of the discrete extra seed layer segments, respectively. The redistribution structure further includes a coating that completely covers each extra patterned conductive feature and is configured to enable each extra patterned conductive feature to have a solderable surface. The coating is formed of one of ENIG, OSP, ENEPIG, and solder alloy.

In one embodiment of the multilevel SIP module, the bottom surface of the bottom mold compound extends vertically beyond a backside surface of the flip-chip die and is coplanar with an end surface of at least one of the copper posts. The bottom mold compound has a number of mold compound holes, and at least one of the mold compound holes is confined within the backside surface of the flip-chip die and extends from the bottom surface of the bottom mold compound to the backside surface of the flip-chip die to partially expose the backside surface of the flip-chip die. The flip-chip die is one of a gallium arsenide (GaAs) die, a Si die, and a gallium nitride (GaN) die.

In one embodiment of the multilevel SIP module, the redistribution structure further includes a seed layer with a number of discrete seed layer segments. The seed layer is in contact with and partially covers the bottom surface of the double-sided module and completely and directly covers exposed surfaces within each mold compound hole, such that the seed layer is in contact with the backside surface of the flip-chip die and the end surface of the at least one of the copper posts. The patterned conductive features are in direct contact with the discrete seed layer segments, respectively, and fill the mold compound holes.

In one embodiment of the multilevel SIP module, the copper posts have different heights, where certain ones of the copper posts have a first height and remaining ones of the copper posts have a second height taller than the first height. The bottom surface of the bottom mold compound extends vertically beyond an end surface of each of the certain ones of the copper posts, and is coplanar with an end surface of each of the remaining ones of the copper posts. The at least one of the copper posts is included in the remaining ones of the copper posts. Certain ones of the mold compound holes are confined within the end surfaces of the certain ones of the copper posts, respectively, and extend from the bottom surface of the bottom mold compound to the end surfaces of the certain ones of the copper posts, respectively, to partially expose each of the certain ones of the copper posts.

In one embodiment of the multilevel SIP module, the redistribution structure further includes a seed layer with a number of discrete seed layer segments. The seed layer is in contact with and partially covers the bottom surface of the double-sided module and completely and directly covers exposed surfaces within each mold compound hole, such that the seed layer is in contact with the backside surface of the flip-chip die and the end surface of each copper post. The patterned conductive features are in direct contact with the discrete seed layer segments, respectively, and fill the mold compound holes.

In one embodiment of the multilevel SIP module, the bottom component is a flip-chip die with a number of die copper pillars. Herein, a backside surface of the flip-chip die is attached to the bottom surface of the laminate body and the die copper pillars extend toward the bottom surface of the double-sided module. Each copper post has a same height and is attached to the bottom surface of the laminate body. The bottom surface of the bottom mold compound, a tip surface of each die copper pillar, and an end surface of each copper post are coplanar and constitute the bottom surface of the double-sided module. The flip-chip die is one of a GaAs die, a Si die, and a GaN die.

In one embodiment of the multilevel SIP module, the redistribution structure further includes a first dielectric pattern with a number of first openings. The first dielectric pattern is located directly underneath the bottom surface of the double-sided module, such that the first dielectric pattern is in contact with the tip surface of each die copper pillar of the flip-chip die, and the end surface of each copper post. The first openings are positioned so that the tip surface of each die copper pillar and the end surface of each copper post are partially exposed. The patterned conductive features fill the first openings to be coupled with the copper posts and the die copper pillars of the bottom component, respectively, and extend underneath the first dielectric pattern.

In one embodiment of the multilevel SIP module, the redistribution structure further includes a seed layer with a number of discrete seed layer segments. The seed layer completely and directly covers exposed surfaces within each first opening and extends underneath portions of the first dielectric pattern, such that the seed layer is in contact with the tip surface of each die copper pillar and the end surface of each copper post. Each patterned conductive feature is in direct contact with a corresponding one of the discrete seed layer segments, such that each patterned conductive feature is coupled to at least one of the bottom component and the copper posts via the corresponding one of the discrete seed layer segments.

According to one embodiment, the multilevel SIP module further includes a shielding structure, which completely covers the top surface of the double-sided module and completely covers the side surfaces of the double-sided module but does not cover the bottom surface of the double-sided module, where the redistribution structure is located.

In one embodiment of the multilevel SIP module, the at least one top component is one of a flip-chip die, a wire-bonding die, a surface mounted device (SMD), a filter, a Si device, a power amplifier (PA), and a passive component.

In one embodiment of the multilevel SIP module, the bottom component is one of a flip-chip die, a SMD, a filter, a Si device, a PA, and a passive component.

In one embodiment of the multilevel SIP module, the redistribution structure further includes a coating that completely covers each patterned conductive feature and is configured to enable each patterned conductive feature to have a solderable surface. The coating is formed of one of ENIG, OSP, ENEPIG, and solder alloy.

In one embodiment of the multilevel SIP module, the redistribution layer is formed of copper.

In one embodiment of the multilevel SIP module, the redistribution layer is configured to provide at least one of a heat dissipation path for the bottom component, a ground plane, an inductive element, and a connection pitch change of the multilevel SIP module.

In one embodiment of the multilevel SIP module, each patterned conductive feature is one of a metal pad, a metal trace, and a metal via.

According to one embodiment, a communication device includes a control system, a baseband processor, receive circuitry, and transmit circuitry. Herein, at least one or any combination of the control system, the baseband processor, the transmit circuitry, and the receive circuitry is implemented in a multilevel SIP module, which includes a double-sided module and a redistribution structure located underneath a bottom surface of the double-sided module. Herein, the double-sided module includes a laminate body, at least one top component, a top mold compound, a bottom component, a number of copper posts, and a bottom mold compound. The at least one top component is attached to a top surface of the laminate body, and the top mold compound is formed on the top surface of the laminate body to encapsulate the at least one top component. The bottom component and the copper posts are attached to a bottom surface of the laminate body, while the bottom mold compound is formed on the bottom surface of the laminate body and at least encapsulates side surfaces of the bottom component and side surfaces of each of the copper posts. A top surface of the double-sided module is a top surface of the top mold compound, side surfaces of the double-sided module are a combination of side surfaces of the top mold compound, side surfaces of the laminate body, and the side surfaces of the bottom mold compound, and a bottom surface of the double-sided module is at least composed of a bottom surface of the bottom mold compound. The redistribution structure includes a redistribution layer with a number of patterned conductive features, which are separate from each other. Each patterned conductive feature is coupled to at least one of the bottom component and the copper posts.

According to one embodiment, a method of fabricating redistribution bottom features for a SIP module starts with providing a double-sided module, which includes a laminate body, at least one top component, a top mold compound, a bottom component, a number of copper posts, and a bottom mold compound. Herein, the at least one top component is attached to a top surface of the laminate body, and the top mold compound is formed on the top surface of the laminate body to encapsulate the at least one top component. The bottom component and the copper posts are attached to a bottom surface of the laminate body, while the bottom mold compound is formed on the bottom surface of the laminate body and at least encapsulates side surfaces of the bottom component and side surfaces of each of the copper posts. A top surface of the double-sided module is a top surface of the top mold compound, side surfaces of the double-sided module are a combination of side surfaces of the top mold compound, side surfaces of the laminate body, and the side surfaces of the bottom mold compound, and a bottom surface of the double-sided module is at least composed of a bottom surface of the bottom mold compound. Next, a redistribution structure is formed, which is located underneath the bottom surface of the double-sided module. The redistribution structure includes a number of patterned conductive features, which are separate from each other. Each patterned conductive feature is coupled to at least one of the bottom component and the copper posts.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 illustrates an example multilevel system-in-package (SIP) module with an example bottom redistribution structure according to some embodiments.
Figure 2 provides a flow diagram that illustrates an example process for fabricating the example bottom redistribution structure of the example multilevel SIP module according to some embodiments of the present disclosure.
Figures 3-12 illustrate alternative multilevel SIP modules with alternative bottom redistribution structures, respectively, and corresponding processes for fabricating these alternative bottom redistribution structures according to some embodiments.
Figure 13 is a block diagram of a communication device, which may include the multilevel SIP illustrated in Figures 1, 3, 5, 7, 9, and 11 according to some embodiments of the present disclosure.

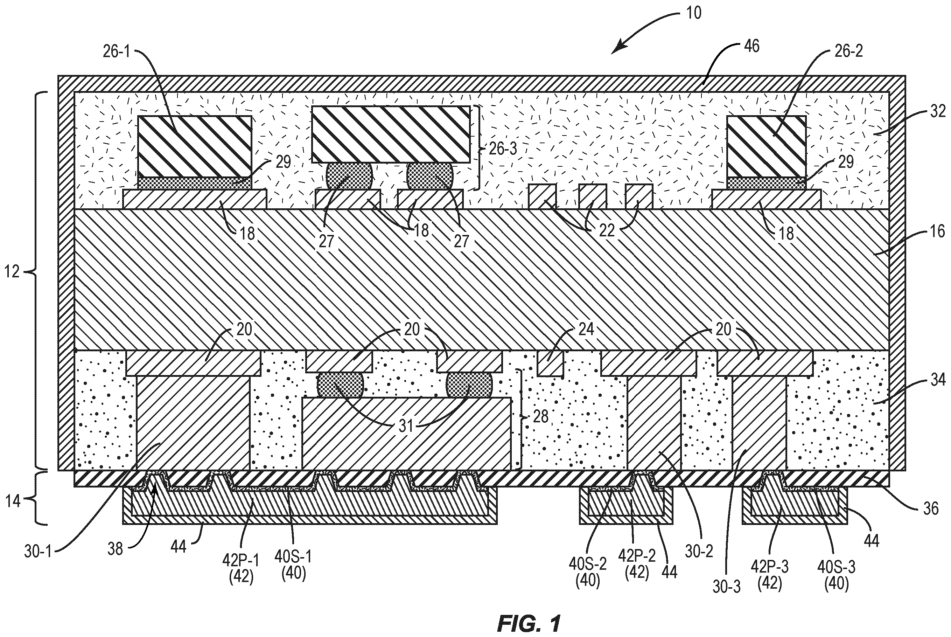

It will be understood that for clarity of illustration, Figures 1-13 may not be drawn to scale.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relative relationship of one element, layer, or region to another element, layer, or region as illustrated in the Figures. It will be understood that these terms and those discussed above are intended to encompass different orientations of the device in addition to the orientation depicted in the Figures. For a non-limiting example, when a structure in the Figures is flipped upside-down, a "below"/ "above" relationship will be swapped.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

The present disclosure relates to a multilevel system-in-package (SIP) module with one or more embedded dies and redistribution bottom features, and a process for fabricating the redistribution bottom features for the multilevel SIP module. In particular, the disclosed multilevel SIP module is composed of a double-sided module and a redistribution structure, where the double-sided module includes the one or more embedded dies and a number of copper posts, while the redistribution structure is formed underneath the double-sided module at the bottom of the SIP module by using photo-defining technologies. The redistribution structure allows for implementation of thermal/ground planes and inductive/matching elements for the multilevel SIP module while providing a uniform connection pitch to a higher-level assembly (e.g., a customer printed circuit board).

Figure 1 illustrates an example multilevel SIP module 10 composed of an example double-sided module 12 and an example redistribution structure 14 underneath the double-sided module 12 according to some embodiments of the present disclosure. Herein, the double-sided module 12 includes a laminate body 16, top pads 18, bottom pads 20, one or more top routing traces 22, one or more bottom routing traces 24, one or more top components 26, one or more bottom components 28, a number of copper posts 30, a top mold compound 32, and a bottom mold compound 34.

The laminate body 16 may have a thickness between 100 µm and 400 µm and be formed from alternating prepreg (PPG) layers and metal layers in a vertical direction (not shown). The top pads 18, the bottom pads 20, the one or more top routing traces 22, and the one or more bottom routing traces 24 are formed of a metal material, such as copper. The top pads 18 are formed on a top surface of the laminate body 16 and configured to accommodate the one or more top components 26. Each top pad 18 may have a same or different size with an appropriate shape, such as a circle, square, etc. The one or more top routing traces 22 are also formed on the top surface of the laminate body 16 and configured to interconnect among certain top pads 18 or connect between certain top pads 18 to the metal layers within the laminate body 16 (not shown).
The bottom pads 20 are formed on a bottom surface of the laminate body 16 and configured to accommodate the one or more bottom components 28 and to accommodate the copper posts 30. Each bottom pad 20 may have a same or different size with an appropriate shape, such as a circle, square, etc. The one or more bottom routing traces 24 are formed on the bottom surface of the laminate body 16 and configured to interconnect among certain bottom pads 20 or connect between certain bottom pads 20 to the metal layers within the laminate body 16 (not shown).

For the purpose of this illustration, the one or more top components 26 include a first top surface mounted device (SMD) 26-1, a second top SMD 26-2, and a top flip-chip die 26-3 with top die solder balls 27. In different applications, there might be fewer or more top components 26 attached on the top surface of the laminate body 16 via corresponding top pads 18, respectively. The top components 26 may be other electrical components, such as wire-bonding dies, flip-chip dies with die copper pillars, filters, Silicon (Si) devices, power amplifiers (PAs), and/or passive components. The top components 26 might be mounted to the top pads 18 with or without an adhesive material (e.g., the first top SMD 26-1 and the second top SMD 26-2 are mounted to corresponding top pads 18 with a top adhesive material 29, while the top die solder balls 27 of the top flip-chip die 26-3 are attached to the corresponding top pads 18 directly). The top components 26 may also be electrically connected to corresponding metal layers within the laminate body 16, respectively (not shown). The top mold compound 32 is formed on the top surface of the laminate body 16 to encapsulate each top component 26, any portion of each top pad 18 not covered by the corresponding top component 26, and the one or more top routing traces 22. The top mold compound 32 may be an organic epoxy resin system or the like.

In addition, for the purpose of this illustration, the one or more bottom components 28 is a bottom flip-chip die, which includes bottom die solder balls 31 attached to the bottom surface of the laminate body 16 via corresponding bottom pads 20, respectively. The copper posts 30, which protrude from the bottom surface of the laminate body 16 and surround the bottom flip-chip die 28, include a first copper post 30-1, a second copper post 30-2, and a third copper post 30-3. In different applications, there might be more bottom components 28 mounted on the bottom surface of the laminate body 16 via corresponding bottom pads 20, respectively, and there might be fewer or more copper posts 30 mounted on the bottom surface of the laminate body 16 via corresponding bottom pads 20, respectively, in a different layout configuration (e.g., all of the copper posts 30 are positioned at one horizontal side of the bottom flip-chip die 28). The bottom components 28 may be other electrical components, such as SMDs, wire-bonding dies, flip-chip dies with die copper pillars, filters, Si devices, PAs, and/or passive components. The bottom component 28 is mounted to the bottom pads 20 with or without adhesive material. Each copper post 30 may have a same height, a same or different horizontal dimension, and an appropriate shape, such as a cylindrical shape, a cube, a cuboid etc. The bottom component 28 and the copper posts 30 may also be electrically connected to corresponding metal layers, respectively, within the laminate body 16 (not shown). The bottom mold compound 34 is formed on the bottom surface of the laminate body 16 to encapsulate any portion of each bottom pad 20 not covered by the corresponding bottom component 28, the one or more bottom routing traces 24, side surfaces of the bottom component 28, and side surfaces of each copper post 30. As such a backside surface of the bottom flip-chip die 28 (herein and hereafter, a backside surface of one flip-chip die refers to a surface away from an active region of the flip-chip die and opposite the die solder balls/die copper pillars), and an end surface of each copper post 30 (herein and hereafter, an end surface of one copper post refers to a surface of the copper post away from the laminate body 16) are exposed through the bottom mold compound 34. The bottom mold compound 34 may be an organic epoxy resin system or the like. The top mold compound 32 and the bottom mold compound 34 may be formed of a same or different material.

Herein, a top surface of the double-sided module 12 is a top surface of the top mold compound 32. Side surfaces of the double-sided module 12 are a combination of side surfaces of the top mold compound 32, side surfaces of the laminate body 16, and the side surfaces of the bottom mold compound 34. A bottom surface of the double-sided module 12 is a combination of a bottom surface the bottom mold compound 34, the backside surface of the bottom flip-chip die 28, and the end surface of each copper post 30 (i.e., the bottom surface the bottom mold compound 34, the backside surface of the bottom flip-chip die 28, and the end surface of each copper post 30 are coplanar).

The redistribution structure 14 underneath the double-sided module 12 includes a first dielectric pattern 36 with a number of first openings 38 (for clarity, only one first opening is labeled with a reference number), a seed layer 40, and a redistribution layer 42. Herein, the first dielectric pattern 36 is located directly underneath the bottom surface of the double-sided module 12, such that the first dielectric pattern 36 is in contact with the bottom surface of the bottom mold compound 34, the backside surface of the bottom flip-chip die 28, and the end surface of each copper post 30. The first openings 38 are positioned so that the backside surface of the bottom flip-chip die 28 and the end surface of each copper post 30 can be partially exposed. For the purpose of this illustration, there are two first openings 38 confined within the end surface of the first copper post 30-1, three first openings 38 confined within the backside surface of the bottom flip-chip die 28, one first opening 38 confined within the end surface of the second copper post 30-2, and one first opening 38 confined within the end surface of the third copper post 30-3. In different applications, there might be fewer or more first openings 38 within the first dielectric pattern 36 to partially expose a backside/end surface of one bottom component 28/copper post 30.

The seed layer 40 completely and directly covers exposed surfaces within each first opening 38 and extends underneath portions of the first dielectric pattern 36. Herein and hereafter, completely covering a surface refers to covering at least 99% of the surface. Typically, the seed layer 40 includes multiple discrete seed layer segments 40S, and each seed layer segment 40S itself is a continuous piece. As shown in this illustration, a first seed layer segment 40S-1 covers all first openings 38 confined within the bottom flip-chip die 28 and the first copper post 30-1, as well as portions of the first dielectric pattern 36 between and adjacent to these first openings 38. A second seed layer segment 40S-2 covers the first opening 38 confined within the second copper post 30-2, as well as portions of the first dielectric pattern 36 adjacent to the corresponding first opening 38. A third seed layer segment 40S-3 covers the first opening 38 confined within the third copper post 30-3, as well as portions of the first dielectric pattern 36 adjacent to the corresponding first opening 38. The first seed layer segment 40S-1, the second seed layer segment 40S-2, and the third seed layer segment 40S-3 are separate from each other.

The redistribution layer 42 may be formed of a metal material (e.g., copper) and includes multiple patterned conductive features 42P, which may be metal pads, metal traces, metal vias, etc. Each patterned conductive feature 42P is in direct contact with a corresponding seed layer segment 40S, which is a deposition/plating base for the patterned conductive feature 42P (more details are described below). As such, each patterned conductive feature 42P fills one or more corresponding first openings 38 and extends underneath the first dielectric pattern 36. In this embodiment, the redistribution layer 42 includes three patterned conductive features 42P. A first patterned conductive feature 42P-1 is in direct contact with the first seed layer segment 40S-1, fills the first openings 38 confined within the bottom flip-chip die 28 and the first copper post 30-1, and is electrically and/or thermally coupled to the bottom flip-chip die 28 and the first copper post 30-1. A second patterned conductive feature 42P-2 is in direct contact with the second seed layer segment 40S-2, fills the first opening 38 confined within the second copper post 30-2, and is electrically and/or thermally coupled to the second copper post 30-2. A third patterned conductive feature 42P-3 is in direct contact with the third seed layer segment 40S-3, fills the first opening 38 confined within the third copper post 30-3, and is electrically and/or thermally coupled to the third copper post 30-3.

In some applications, the seed layer 40 might be omitted, such that the redistribution layer 42 might be in direct contact with the backside surface of the bottom flip-chip die 28 and the end surface of each copper post 30 (not shown) and still fills each first opening 38. In some applications, the redistribution layer 42 may include fewer or more patterned conductive features 42P with different coverages, and the seed layer 40 may include fewer or more discrete seed layer segments 40S corresponding to the discrete patterned conductive features 42P. In addition, the redistribution structure 14 may further include a coating 44 that completely covers each patterned conductive feature 42P and is configured to enable each patterned conductive feature 42P to have a solderable surface. The coating 44 may be formed of electroless nickel immersion gold (ENIG), organic solderability preservatives (OSP), electroless nickel electroless palladium immersion gold (ENEPIG), solder alloy, or other materials as long as they may preserve solderability of the patterned conductive features 42P.

It is clearly noted that the redistribution structure 14 enables metallization (e.g., the first patterned conductive feature 42P-1) underneath the bottom flip-chip die 28, so as to provide an extra heat dissipation path for the bottom flip-chip die 28. In addition, a certain patterned conductive feature 42P (e.g., the first patterned conductive feature 42P-1) may have a size large enough to implement a ground plane and/or an inductive/matching element. The redistribution structure 14 may also change the connection pitch for the multilevel SIP module 10 (e.g., the first, second, and third patterned conductive features 42P-1, 42P-2, and 42P-3 are positioned at substantially equal spacing). Without the redistribution structure 14, the copper posts 30 themselves cannot enhance the heat dissipation performance for the bottom flip-chip die 28 and may not provide a large pad for a ground plane and/or an inductive/matching element. In addition, without the redistribution structure 14, the copper posts 30 themselves will provide a non-uniform pitch for a higher-level assembly (e.g., the second copper post 30-2 and the third copper post 30-3 are positioned in a finer pitch, while the first copper post 30-1 is positioned relatively far away from the second and third copper posts 30-2 and 30-3).

Furthermore, the multilevel SIP module 10 may further include a shielding structure 46, which completely covers the top surface of the double-sided module 12 and completely covers the side surfaces of the double-sided module 12, but does not cover the bottom surface of the double-sided module 12, where the redistribution structure 14 is located. The shielding structure 46 may include two or more stacked layers and be formed of two or more of copper, aluminum, silver, gold, nickel, and other conductive materials.

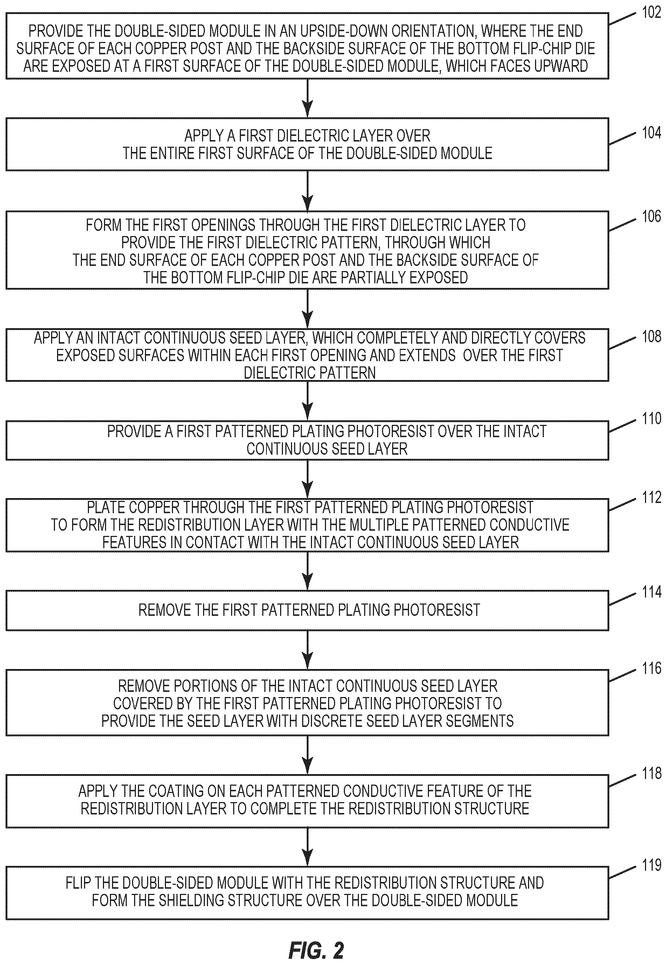

Figure 2 provides a flow diagram that illustrates an example process for fabricating the redistribution structure 14 of the multilevel SIP module 10 shown in Figure 1 according to some embodiments of the present disclosure. Although the flow diagram and the associated steps are illustrated in a series, they are not necessarily order dependent. Some steps may be done in a different order than that presented. Further, processes within the scope of this disclosure may include fewer or more steps than those illustrated in Figure 2.

Initially, the double-sided module 12 with the bottom component 28 and the copper posts 30 is provided in an upside-down orientation (step 102), such that the bottom surface and the top surface of the double-sided module 12 are swapped. Herein, for the sake of clarity, a first surface and a second surface (opposite the first surface) are respectively used to represent the bottom surface and the top surface of the double-sided module 12 in the original orientation (as shown in Figure 1). The backside surface of the bottom flip-chip die 28 and the end surface of each copper post 30 are exposed at the first surface (i.e., the original bottom surface) of the double-sided module 12, which faces upward. The second surface (i.e., the original top surface) of the double-sided module 12 faces downward. Herein, a grinding process may be utilized to expose the backside surface of the bottom flip-chip die 28 and the end surface of each copper post 30.

Next, a first dielectric layer is applied over the entire first surface of the double-sided module 12 (step 104). The first dielectric layer may be a photo-imageable dielectric (PID) layer or a non-photo-imageable film (such as a build-up film). The first openings 38 are then formed through the first dielectric layer to provide the first dielectric pattern 36 (step 106). The first openings 38 are formed at positions so that the backside surface of the bottom flip-chip die 28 and the end surface of each copper post 30 can be partially exposed. Each first opening 38 is confined within the backside surface of the bottom flip-chip die 28 or one end surface of a corresponding copper post 30. The first openings 38 may be formed by laser drill photo-imaging (for the PID layer), which does not require a protective mask, or a laser ablation (for the non-photo-imageable film).

An intact continuous seed layer is applied over the first dielectric pattern 36 and completely and directly covers exposed surfaces within each first opening 38 (step 108). A first patterned plating photoresist is then provided over the intact continuous seed layer (step 110). First portions of the intact continuous seed layer are covered by the first patterned plating photoresist, while second portions of the intact continuous seed layer are exposed through the first patterned plating photoresist (i.e., the second portions of the intact continuous seed layer are the discrete seed layer segments 40S of the seed layer 40 in the final product). Each first opening 38 is confined within the second portions of the intact continuous seed layer and is not covered by the first patterned plating photoresist. Next, copper is plated through the first patterned plating photoresist to form the redistribution layer 42 with the multiple patterned conductive features 42P (step 112). Herein, the intact continuous seed layer (especially the second portions of the intact continuous seed layer) is the plating base for the patterned conductive features 42P. Each patterned conductive feature 42P covers and is in contact with a corresponding second portion of the intact continuous seed layer and fills one or more corresponding first openings 38.

After the redistribution layer 42 is formed, the first patterned plating photoresist is removed (step 114), and the first portions of the intact continuous seed layer covered by the first patterned plating photoresist are also removed (step 116). The first portions of the intact continuous seed layer might be removed by an etching process. The second portions of the intact continuous seed layer, which are covered by the patterned conductive features 42P, respectively (i.e., not covered by the first patterned plating photoresist), are retained and become the discrete segments 40S that constitute the seed layer 40. The coating 44 is then applied to each patterned conductive feature 42P of the redistribution layer 42 to complete the redistribution structure 14 at the first surface of the double-sided module 12 (step 118). The coating 44 completely covers each patterned conductive feature 42P and is configured to enable each patterned conductive feature 42P to have a solderable surface. The coating 44 may be formed of ENIG, OSP, ENEPIG, solder alloy, or other materials as long as they may preserve solderability of the patterned conductive features 42P.

Lastly, the double-sided module 12 with the redistribution structure 14 is flipped upside-down back to its original orientation, and the shielding structure 46 is formed over the double-sided module 12 to provide the multilevel SIP module 10 (step 119). Herein, the redistribution structure 14 is located underneath the double-sided module 12 at the first surface of the double-sided module 12, and the second surface of the double-sided module 12 faces upwards. The shielding structure 46 completely covers the second (top) surface of the double-sided module 12 and completely covers the side surfaces of the double-sided module 12 but does not cover the first (bottom) surface of the double-sided module 12, where the redistribution structure 14 is located.

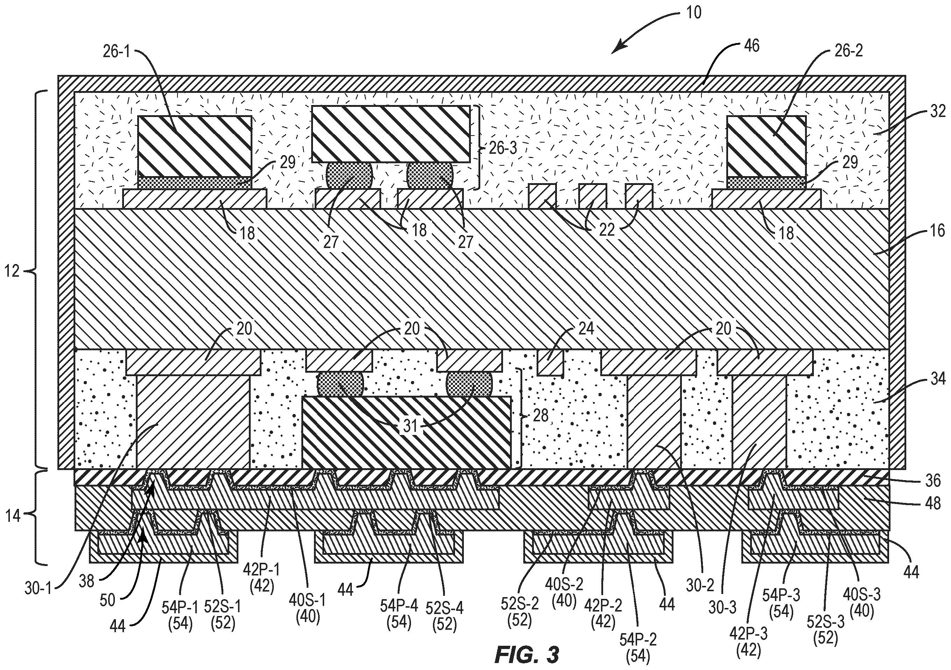

In order to provide a uniform connection pitch with a consistent feature size, the redistribution structure 14 underneath the double-sided module 12 may further include extra levels. As illustrated in Figure 3, besides the first dielectric pattern 36, the seed layer 40, and the redistribution layer 42, the redistribution structure 14 may also include a second dielectric pattern 48 with second openings 50, an extra seed layer 52, and an extra redistribution layer 54. The second dielectric pattern 48 is located underneath the first dielectric pattern 36 to partially encapsulate each patterned conductive feature 42P. One or more portions of each patterned conductive feature 42P are exposed through a corresponding one or more second openings 50 of the second dielectric pattern 48. For the purpose of this illustration, there are four second openings 50 confined within the first patterned conductive feature 42P-1, one second opening 50 confined within the second patterned conductive feature 42P-2, and one second opening 50 confined within the third patterned conductive feature 42P-3. In different applications, there might be fewer or more second openings 50 to partially expose one patterned conductive feature 42P.

The extra seed layer 52 completely and directly covers exposed surfaces within each second opening 50 and extends underneath portions of the second dielectric pattern 48. As shown in this illustration, the extra seed layer 52 includes four discrete segments 52S. A first extra seed layer segment 52S-1 covers two second openings 50 confined within a first portion of the first patterned conductive feature 42P-1 (e.g., a left portion of the first patterned conductive feature 42P-1) and covers portions of the second dielectric pattern 48 between and adjacent to these two second openings 50. A second extra seed layer segment 52S-2 covers one second opening 50 confined within the second patterned conductive feature 42P-2, as well as portions of the second dielectric pattern 48 adjacent to the corresponding second opening 50. A third extra seed layer segment 52S-3 covers one second opening 50 confined within the third patterned conductive feature 42P-3, as well as portions of the second dielectric pattern 48 adjacent to the corresponding second opening 50. A fourth extra seed layer segment 52S-4 covers two second openings 50 confined within a second portion of the first patterned conductive feature 42P-1 (e.g., a right portion of the first patterned conductive feature 42P-1) and covers portions of the second dielectric pattern 48 between and adjacent to these two second openings 50. The first extra seed layer segment 52S-1, the second extra seed layer segment 52S-2, the third extra seed layer segment 52S-3, and the fourth extra seed layer segment 52S-4 are separate from each other.

The extra redistribution layer 54 may be formed of copper and includes multiple discrete extra patterned conductive features 54P, which may be metal pads, metal traces, metal vias, etc. Each extra patterned conductive feature 54P is in direct contact with a corresponding extra seed layer segment 52S, which is a deposition/plating base for the extra patterned conductive feature 54P (more details are described below). As such, each extra patterned conductive feature 54P fills one or more corresponding second openings 50 and extends underneath the second dielectric pattern 48. In this embodiment, the extra redistribution layer 54 includes four extra patterned conductive features 54P. A first extra patterned conductive feature 54P-1 is in direct contact with the first extra seed layer segment 52S-1, fills two second openings 50 confined within the first portion of the first patterned conductive feature 42P-1, and is electrically and/or thermally coupled to the first patterned conductive feature 42P-1. A second extra patterned conductive feature 54P-2 is in direct contact with the second extra seed layer segment 52S-2, fills the second opening 50 confined within the second patterned conductive feature 42P-2, and is electrically and/or thermally coupled to the second patterned conductive feature 42P-2. A third extra patterned conductive feature 54P-3 is in direct contact with the third extra seed layer segment 52S-3, fills the second opening 50 confined within the third patterned conductive feature 42P-3, and is electrically and/or thermally coupled to the third patterned conductive feature 42P-3. A fourth extra patterned conductive feature 54P-4 is in direct contact with the fourth extra seed layer segment 52S-4, fills two second openings 50 confined within the second portion of the first patterned conductive feature 42P-1, and is electrically and/or thermally coupled to the first patterned conductive feature 42P-1.

Herein, the extra patterned conductive features 54P may have the same size and be separate from each other with a same spacing, thereby providing a uniform connection pitch with a consistent feature size for the multilevel SIP module 10. In some applications, the extra seed layer 52 might be omitted, such that the extra redistribution layer 54 might be in direct contact with each patterned conductive feature 42P (not shown) and still fills each second opening 50. In some applications, the extra redistribution layer 54 may include fewer or more extra patterned conductive features 54P with different coverage/positions, and the extra seed layer 52 may include fewer or more discrete extra seed layer segments 52S corresponding to the discrete extra patterned conductive features 54P. The second patterned dielectric 48 and the extra redistribution layer 54 may also enable extra embedded features in the redistribution structure 14, such as inductors. In addition, the redistribution structure 14 may further include the coating 44 that completely covers each extra patterned conductive feature 54P and is configured to enable each extra patterned conductive feature 54P to have a solderable surface. The coating 44 may be formed of ENIG, OSP, ENEPIG, solder alloy, or other materials as long as they may preserve solderability of the extra patterned conductive features 54P.

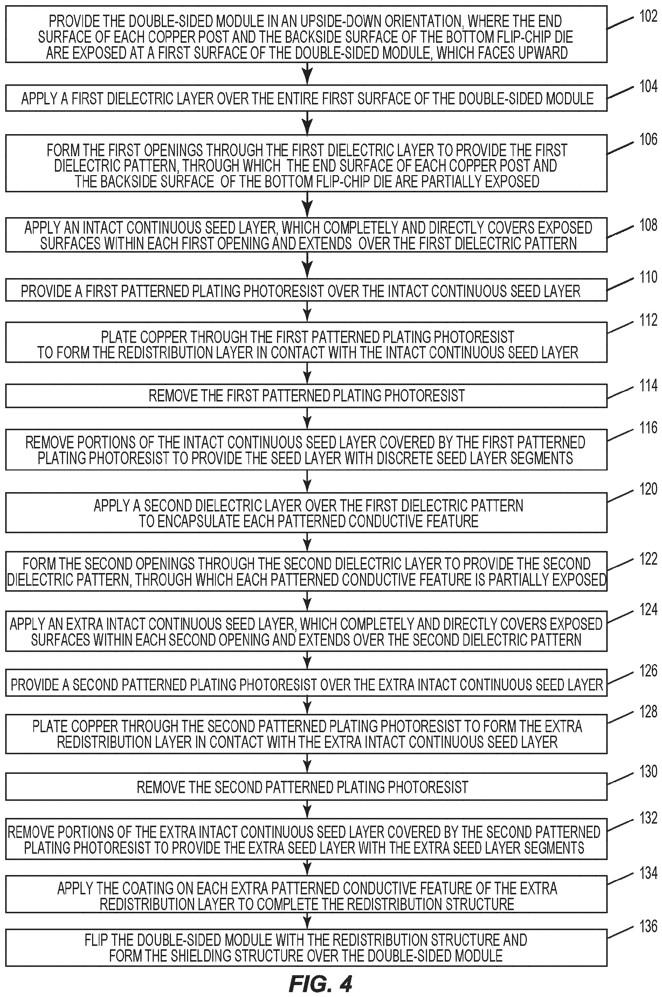

Figure 4 provides a flow diagram that illustrates an example process for fabricating the redistribution structure 14 of the multilevel SIP module 10 shown in Figure 3 according to some embodiments of the present disclosure. Although the flow diagram and the associated steps are illustrated in a series, they are not necessarily order dependent. Some steps may be done in a different order than that presented. Further, processes within the scope of this disclosure may include fewer or more steps than those illustrated in Figure 4. The flow diagram illustrated in Figure 4 includes the same process steps 102-116 as shown in Figure 2, and further includes process steps for providing the second dielectric pattern 48 with the second openings 50, the extra seed layer 52, and the extra redistribution layer 54 to complete the redistribution structure 14.

After the redistribution layer 42 is formed, the first patterned plating photoresist is removed, and the seed layer 40 with the discrete seed layer segments 40S is provided, a second dielectric layer is applied over the first dielectric pattern 36 to encapsulate each patterned conductive feature 42P (step 120). The second dielectric layer may be a PID layer or a non-photo-imageable film (such as a build-up film). The second openings 50 are then formed through the second dielectric layer to provide the second dielectric pattern 48 (step 122). The second openings 50 are formed at positions so that each patterned conductive feature 42P can be partially exposed. Each second opening 50 is confined within one of the patterned conductive features 42P. The second openings 50 may be formed by laser drill photo-imaging (for the PID layer), or a laser ablation (for the non-photo-imageable film).

An extra intact continuous seed layer is applied over the second dielectric pattern 48 and completely and directly covers exposed surfaces within each second opening 50 (step 124). A second patterned plating photoresist is then provided over the extra intact continuous seed layer (step 126). First portions of the extra intact continuous seed layer are covered by the second patterned plating photoresist, while second portions of the extra intact continuous seed layer are exposed through the second patterned plating photoresist (i.e., the second portions of the extra intact continuous seed layer are the discrete extra seed layer segments 52S of the extra seed layer 52 in the final product). Herein, each second opening 50 is confined within the second portions of the extra intact continuous seed layer and is not covered by the second patterned plating photoresist. Next, copper is plated through the second patterned plating photoresist to form the extra redistribution layer 54 with the discrete extra patterned conductive features 54P (step 128). Herein, the extra intact continuous seed layer (especially the second portions of the extra intact continuous seed layer) is the plating base for the extra patterned conductive features 54P. Each extra patterned conductive feature 54P covers and is in contact with a corresponding second portion of the extra intact continuous seed layer and fills one or more corresponding second openings 50.

After the extra redistribution layer 54 is formed, the second patterned plating photoresist is removed (step 130), and the first portions of the extra intact continuous seed layer covered by the second patterned plating photoresist are also removed (step 132). The first portions of the extra intact continuous seed layer might be removed by an etching process. The second portions of the extra intact continuous seed layer, which are covered by the extra patterned conductive features 54P, respectively (i.e., not covered by the second patterned plating photoresist), are retained and become the discrete extra seed layer segments 52S that constitute the extra seed layer 52. The coating 44 is then applied to each extra patterned conductive feature 54P of the extra redistribution layer 54 to complete the redistribution structure 14 (step 134). The coating 44 completely covers each extra patterned conductive feature 54P and is configured to enable each extra patterned conductive feature 54P to have a solderable surface. The coating 44 may be formed of ENIG, OSP, ENEPIG, solder alloy, or other materials as long as they may preserve solderability of the extra patterned conductive features 54P.

Lastly, the double-sided module 12 with the redistribution structure 14 is flipped upside-down back to its original orientation, and the shielding structure 46 is formed over the double-sided module 12 to provide the multilevel SIP module 10 (step 136). Herein, the redistribution structure 14 is located underneath the double-sided module 12 at the first surface of the double-sided module 12, and the second surface of the double-sided module 12 faces upwards. The shielding structure 46 completely covers the second (top) surface of the double-sided module 12 and completely covers the side surfaces of the double-sided module 12 but does not cover the first (bottom) surface of the double-sided module 12, where the redistribution structure 14 is located.

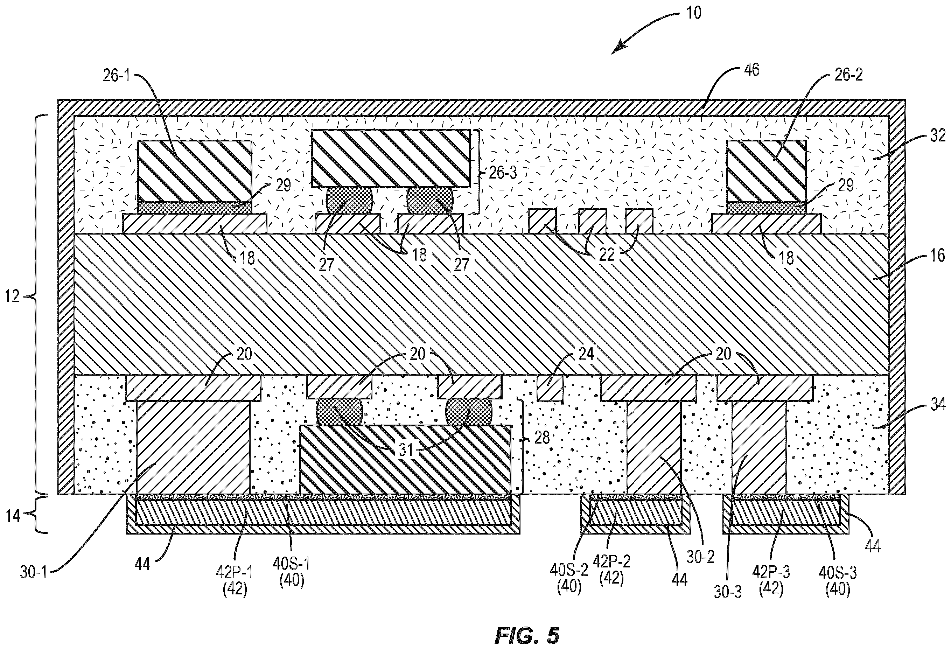

In some embodiments, the first dielectric pattern 36 may be omitted in the redistribution structure 14 of the multilevel SIP module 10, as illustrated in Figure 5. Herein, the bottom surface of the double-sided module 12 is the combination of the bottom surface of the bottom mold compound 34, the backside surface of the bottom flip-chip die 28, and the bottom surface of each copper post 30. The seed layer 40 is in contact with and partially covers the bottom surface of the double-sided module 12. For the purpose of this illustration, the seed layer 40 includes three discrete seed layer segments 40S. The first seed layer segment 40S-1 covers the backside surface of the bottom flip-chip die 28, the end surface of the first copper post 30-1, and a portion of the bottom surface of the bottom mold compound 34 between the bottom flip-chip die 28 and the first copper post 30-1. The second seed layer segment 40S-2 covers the end surface of the second copper post 30-2 and portions of the bottom surface of the bottom mold compound 34 adjacent to the second copper post 30-2. The third seed layer segment 40S-3 covers the end surface of the third copper post 30-3 and portions of the bottom surface of the bottom mold compound 34 adjacent to the third copper post 30-3. The first seed layer segment 40S-1, the second seed layer segment 40S-2, and the third seed layer segment 40S-3 are separate from each other.

Each patterned conductive feature 42P is still in direct contact with a corresponding seed layer segment 40S to be coupled to the bottom flip-chip die 28 and/or a corresponding copper post(s) 30. In this embodiment, the redistribution layer 42 includes the first patterned conductive feature 42P-1 in direct contact with the first seed layer segment 40S-1 (e.g., covering the backside surface of the bottom flip-chip die 28, the end surface of the first copper post 30-1, and the portion of the bottom surface of the bottom mold compound 34 between the bottom flip-chip die 28 and the first copper post 30-1), the second patterned conductive feature 42P-2 in direct contact with the second seed layer segment 40S-2 (e.g., covering the end surface of the second copper post 30-2 and the portions of the bottom surface of the bottom mold compound 34 adjacent to the second copper post 30-2), and the third patterned conductive feature 42P-3 in direct contact with the third seed layer segment 40S-3 (e.g., covering the end surface of the third copper post 30-3 and portions of the bottom surface of the bottom mold compound 34 adjacent to the third copper post 30-3).

In some applications, the seed layer 40 might be omitted, such that the redistribution layer 42 might be in direct contact with the backside surface of the bottom flip-chip die 28 and the end surface of each copper post 30 (not shown). In some applications, the redistribution layer 42 may include fewer or more patterned conductive features 42P with different coverages, and the seed layer 40 may include fewer or more discrete seed layer segments 40S corresponding to the discrete patterned conductive features 42P. In addition, the redistribution structure 14 may further include the coating 44 that completely covers each patterned conductive feature 42P and is configured to enable each patterned conductive feature 42P to have a solderable surface. The coating 44 may be formed of ENIG, OSP, ENEPIG, solder alloy, or other materials as long as they may preserve solderability of the patterned conductive features 42P.

In this illustration, the redistribution structure 14 also provides an extra heat dissipation path for the bottom flip-chip die 28 and may have a certain large feature (e.g., the first patterned conductive feature 42P-1) to implement a ground plane and/or an inductive/matching element. The redistribution structure 14 enables variations in the connection pitch of the multilevel SIP module 10 (e.g., the first, second, and third patterned conductive features 42P-1, 42P-2, and 42P-3 are positioned at substantially equal spacing).

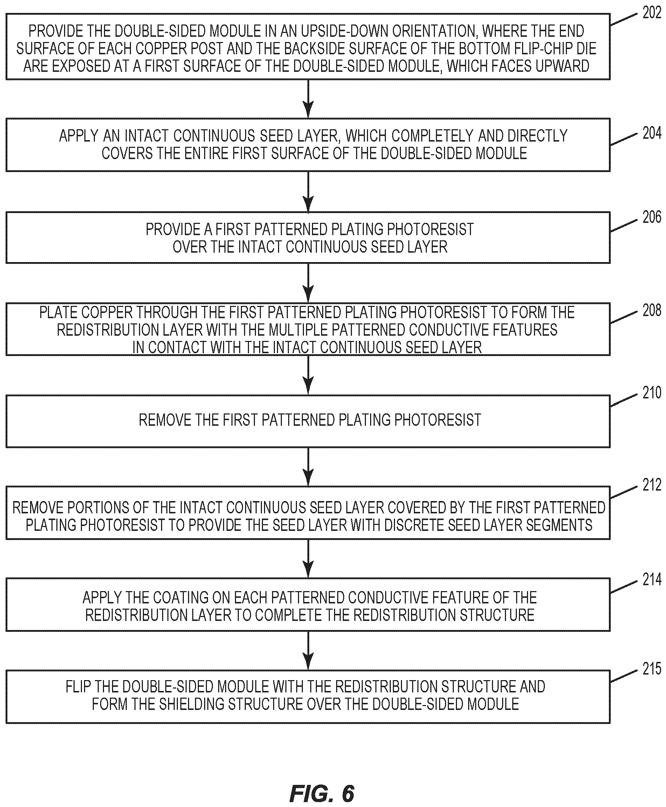

Figure 6 provides a flow diagram that illustrates an example process for fabricating the redistribution structure 14 of the multilevel SIP module 10 shown in Figure 5 according to some embodiments of the present disclosure. Although the flow diagram and the associated steps are illustrated in a series, they are not necessarily order dependent. Some steps may be done in a different order than that presented. Further, processes within the scope of this disclosure may include fewer or more steps than those illustrated in Figure 6.

Initially, the double-sided module 12 with the bottom component 28 and the copper posts 30 is provided in an upside-down orientation (step 202, similar to step 102), such that the bottom surface and the top surface of the double-sided module 12 are swapped. Herein, for the sake of clarity, a first surface and a second surface (opposite the first surface) are respectively used to represent the bottom surface and the top surface of the double-sided module 12 in the original orientation (as shown in Figure 5). The backside surface of the bottom flip-chip die 28 and the end surface of each copper post 30 are exposed at the first surface (i.e., the original bottom surface) of the double-sided module 12, which faces upward. The second surface (i.e., the original top surface) of the double-sided module 12 faces downward. Herein, a grinding process may be applied to expose the backside surface of the bottom flip-chip die 28 and the end surface of each copper post 30.

Next, an intact continuous seed layer is applied over and completely and directly covers the entire first surface of the double-sided module 12 (step 204). A first patterned plating photoresist is then provided over the intact continuous seed layer (step 206). First portions of the intact continuous seed layer are covered by the first patterned plating photoresist, while second portions of the intact continuous seed layer are exposed through the first patterned plating photoresist (i.e., the second portions of the intact continuous seed layer are the discrete seed layer segments 40S of the seed layer 40 in the final product). Herein, the end surface of each copper post 30 and the backside surface of the bottom component 28 are not covered by the first patterned plating photoresist. Copper is then plated through the first patterned plating photoresist to form the redistribution layer 42 with the discrete patterned conductive features 42P (step 208). The intact continuous seed layer (especially the second portions of the intact continuous seed layer) is the plating base for the patterned conductive features 42P. Each patterned conductive feature 42P covers and is in contact with a corresponding second portion of the intact continuous seed layer.

After the redistribution layer 42 is formed, the first patterned plating photoresist is removed (step 210), and the first portions of the intact continuous seed layer covered by the first patterned plating photoresist are also removed (step 212). The first portions of the intact continuous seed layer might be removed by an etching process. The second portions of the intact continuous seed layer, which are covered by the patterned conductive features 42, respectively (i.e., not covered by the first patterned plating photoresist), are retained and become the discrete seed layer segments 40S that constitute the seed layer 40. The coating 44 is then applied to each patterned conductive feature 42P of the redistribution layer 42 to complete the redistribution structure 14 at the first surface of the double-sided module 12 (step 214). The coating 44 completely covers each patterned conductive feature 42P and is configured to enable each patterned conductive feature 42P to have a solderable surface. The coating 44 may be formed of ENIG, OSP, ENEPIG, solder alloy, or other materials as long as they may preserve solderability of the patterned conductive features 42P.

Lastly, the double-sided module 12 with the redistribution structure 14 is flipped upside-down back to its original orientation, and the shielding structure 46 is formed over the double-sided module 12 to provide the multilevel SIP module 10 (step 215). Herein, the redistribution structure 14 is located underneath the double-sided module 12 at the first surface of the double-sided module 12, and the second surface of the double-sided module 12 faces upwards. The shielding structure 46 completely covers the second (top) surface of the double-sided module 12 and completely covers the side surfaces of the double-sided module 12 but does not cover the first (bottom) surface of the double-sided module 12, where the redistribution structure 14 is located.

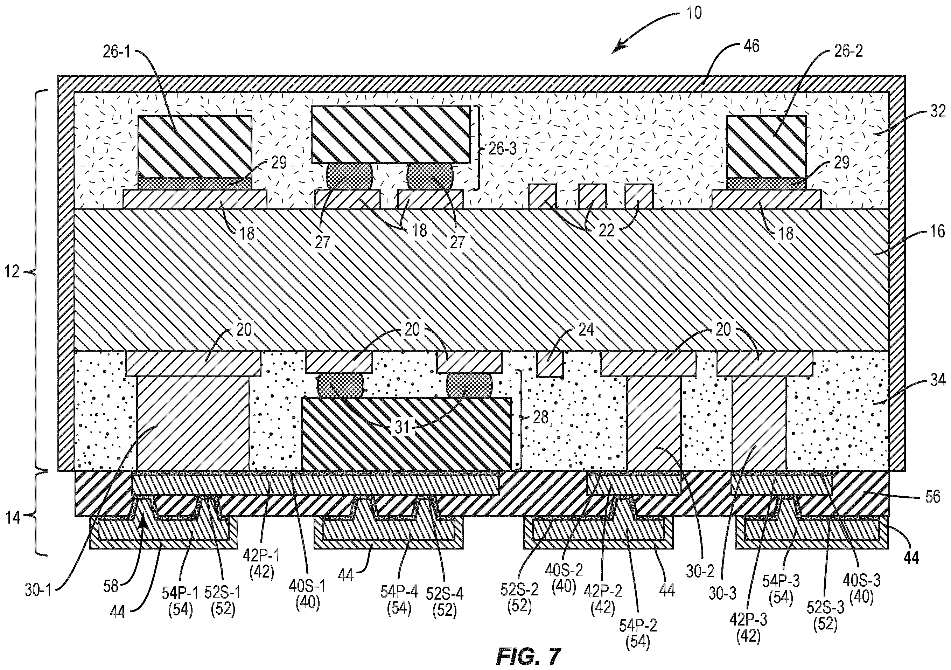

To provide a uniform connection pitch with a consistent feature size for the multilevel SIP module 10, the redistribution structure 14 may further include the extra redistribution layer 54 with the discrete extra patterned conductive features 54P as well as a dielectric pattern 56 with openings 58 (for clarity, only one opening is labeled with a reference number), as illustrated in Figure 7. The dielectric pattern 56 is located underneath the bottom surface of the double-sided module 12 to partially encapsulate each patterned conductive feature 42P. One or more portions of each patterned conductive feature 42P are exposed through a corresponding one or more openings 58 of the dielectric pattern 56. For the purpose of this illustration, there are four openings 58 confined within the first patterned conductive feature 42P-1, one opening 58 confined within the second patterned conductive feature 42P-2, and one opening 58 confined within the third patterned conductive feature 42P-3. In different applications, there might be fewer or more openings 58 in the dielectric pattern 56 to partially expose one patterned conductive feature 42P.

The extra seed layer 52 completely and directly covers exposed surfaces within each opening 58 and extends underneath portions of the dielectric pattern 56. As shown in this illustration, the extra seed layer 52 includes four discrete extra seed layer segments 52S. The first extra seed layer segment 52S-1 covers two openings 58 confined within the first portion of the first patterned conductive feature 42P-1 (e.g., the left portion of the first patterned conductive feature 42P-1) and covers portions of the dielectric pattern 56 between and adjacent to these two openings 58. The second extra seed layer segment 52S-2 covers one opening 58 confined within the second patterned conductive feature 42P-2, as well as portions of the dielectric pattern 56 adjacent to the corresponding opening 58. The third extra seed layer segment 52S-3 covers one opening 58 confined within the third patterned conductive feature 42P-3, as well as portions of the dielectric pattern 56 adjacent to the corresponding opening 58. The fourth extra seed layer segment 52S-4 covers two openings 58 confined within the second portion of the first patterned conductive feature 42P-1 (e.g., the right portion of the first patterned conductive feature 42P-1) and covers portions of the dielectric pattern 56 between and adjacent to these two openings 58. The first extra seed layer segment 52S-1, the second extra seed layer segment 52S-2, the third extra seed layer segment 52S-3, and the fourth extra seed layer segment 52S-4 are separate from each other.

Each extra patterned conductive feature 54P is in direct contact with a corresponding extra seed layer segment 52S, which is a deposition/plating base for the extra patterned conductive feature 54 (more details are described below). As such, each extra patterned conductive feature 54P fills one or more corresponding openings 58 and extends underneath the dielectric pattern 56. In this embodiment, the extra redistribution layer 54 includes four extra patterned conductive features 54P. The first extra patterned conductive feature 54P-1 is in direct contact with the first extra seed layer segment 52S-1 and fills two openings 58 confined within the first portion of the first patterned conductive feature 42P-1. The second extra patterned conductive feature 54P-2 is in direct contact with the second extra seed layer segment 52S-2 and fills the opening 58 confined within the second patterned conductive feature 42P-2. The third extra patterned conductive feature 54P-3 is in direct contact with the third extra seed layer segment 52S-3 and fills the opening 58 confined within the third patterned conductive feature 42P-3, The fourth extra patterned conductive feature 54P-4 is in direct contact with the fourth extra seed layer segment 52S-4 and fills two openings 58 confined within the second portion of the first patterned conductive feature 42P-1. Herein, the extra patterned conductive features 54P may have the same size and be separate from each other with a same spacing, thereby providing a uniform connection pitch with a consistent feature size for the multilevel SIP module 10.

In some applications, the extra seed layer 52 might be omitted, such that the extra redistribution layer 54 might be in direct contact with each patterned conductive feature 42P (not shown) and still fills each opening 58 within the dielectric pattern 56. In some applications, the extra redistribution layer 54 may include fewer or more extra patterned conductive features 54P with different coverage/positions, and the extra seed layer 52 may include fewer or more discrete extra seed layer segments 52S corresponding to the discrete extra patterned conductive features 54P. The dielectric pattern 56 and the extra patterned conductive features 54P may also enable extra embedded features in the redistribution structure 14, such as inductors. In addition, the redistribution structure 14 may further include the coating 44 that completely covers each extra patterned conductive feature 54P and is configured to enable each extra patterned conductive feature 54P to have a solderable surface. The coating 44 may be formed of ENIG, OSP, ENEPIG, solder alloy, or other materials as long as they may preserve solderability of the extra patterned conductive features 54P.

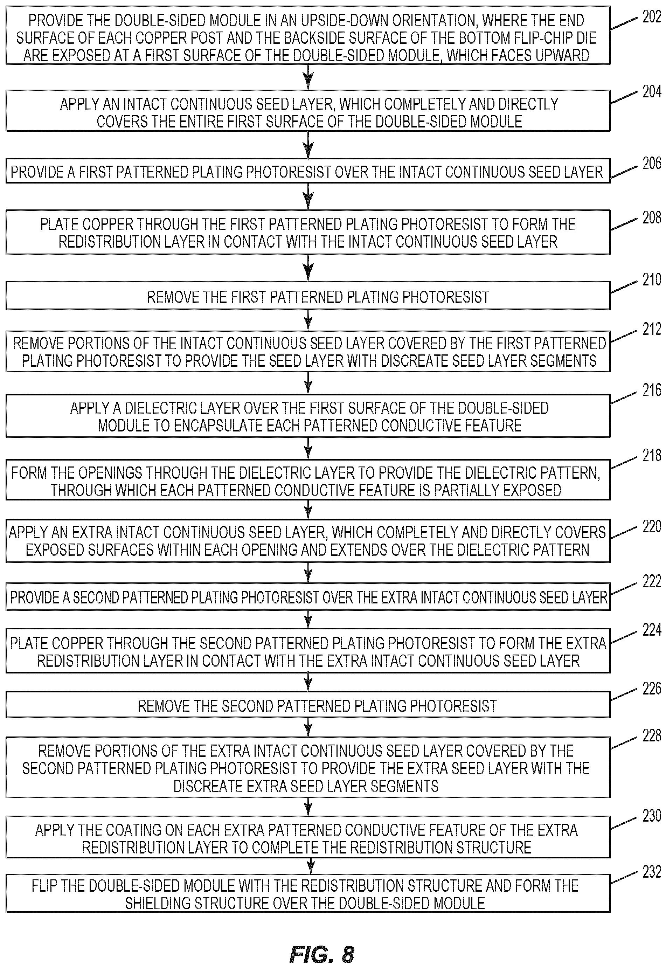

Figure 8 provides a flow diagram that illustrates an example process for fabricating the redistribution structure 14 of the multilevel SIP module 10 shown in Figure 7 according to some embodiments of the present disclosure. Although the flow diagram and the associated steps are illustrated in a series, they are not necessarily order dependent. Some steps may be done in a different order than that presented. Further, processes within the scope of this disclosure may include fewer or more steps than those illustrated in Figure 8. The flow diagram illustrated in Figure 8 includes the same process steps 202-212 as shown in Figure 6, and further includes process steps for providing the dielectric pattern 56 with the openings 58, the extra seed layer 52, and the extra redistribution layer 54 to complete the redistribution structure 14.

After the redistribution layer 42 is formed, the first patterned plating photoresist is removed, and the seed layer 40 with the discrete seed layer segments 40S is provided, a dielectric layer is applied over the first surface (e.g., the original bottom surface) of the double-sided module 12 to encapsulate each patterned conductive feature 42P (step 216). The dielectric layer may be a PID layer or a non-photo-imageable film (such as a build-up film). The openings 58 are then formed through the dielectric layer to provide the dielectric pattern 56 (step 218). The openings 58 are formed at positions so that each patterned conductive feature 42P can be partially exposed. Each opening 58 is confined within one of the patterned conductive features 42P. The openings 58 may be formed by laser drill photo-imaging (for the PID layer), or a laser ablation (for the non-photo-imageable film).

An extra intact continuous seed layer is applied over the dielectric pattern 56 and completely and directly covers exposed surfaces within each opening 58 (step 220). A second patterned plating photoresist is then provided over the extra intact continuous seed layer (step 222). First portions of the intact continuous seed layer are covered by the second patterned plating photoresist, while second portions of the intact continuous seed layer are exposed through the second patterned plating photoresist (i.e., the second portions of the extra intact continuous seed layer are the discrete extra seed layer segments 52S of the extra seed layer 52 in the final product). Herein, each opening 58 is confined within the second portions of the extra intact continuous seed layer and is not covered by the second patterned plating photoresist. Next, copper is plated through the second patterned plating photoresist to form the extra redistribution layer 54 with the discrete extra patterned conductive features 54P (step 224). Herein, the extra intact continuous seed layer (especially the second portions of the extra intact continuous seed layer) is the plating base for the extra patterned conductive features 54P. Each extra patterned conductive feature 54P covers and is in contact with a corresponding second portion of the extra intact continuous seed layer and fills one or more corresponding openings 58.

After the extra redistribution layer 54 is formed, the second patterned plating photoresist is removed (step 226), and the first portions of the extra intact continuous seed layer covered by the second patterned plating photoresist are also removed (step 228). The first portions of the extra intact continuous seed layer might be removed by an etching process. The second portions of the extra intact continuous seed layer, which are covered by the extra patterned conductive features 54P, respectively (i.e., not covered by the second patterned plating photoresist), are retained and become the discrete extra seed layer segments 52S that constitute the extra seed layer 52. The coating 44 is then applied to each extra patterned conductive feature 54P of the extra redistribution layer 54 to complete the redistribution structure 14 (step 230). The coating 44 completely covers each extra patterned conductive feature 54P and is configured to enable each extra patterned conductive feature 54P to have a solderable surface. The coating 44 may be formed of ENIG, OSP, ENEPIG, solder alloy, or other materials as long as they may preserve solderability of the extra patterned conductive features 54P.

Lastly, the double-sided module 12 with the redistribution structure 14 is flipped upside-down back to its original orientation, and the shielding structure 46 is formed over the double-sided module 12 to provide the multilevel SIP module 10 (step 232). Herein, the redistribution structure 14 is located underneath the double-sided module 12 at the first surface of the double-sided module 12, and the second surface of the double-sided module 12 faces upwards. The shielding structure 46 completely covers the second (top) surface of the double-sided module 12 and completely covers the side surfaces of the double-sided module 12 but does not cover the first (bottom) surface of the double-sided module 12, where the redistribution structure 14 is located.

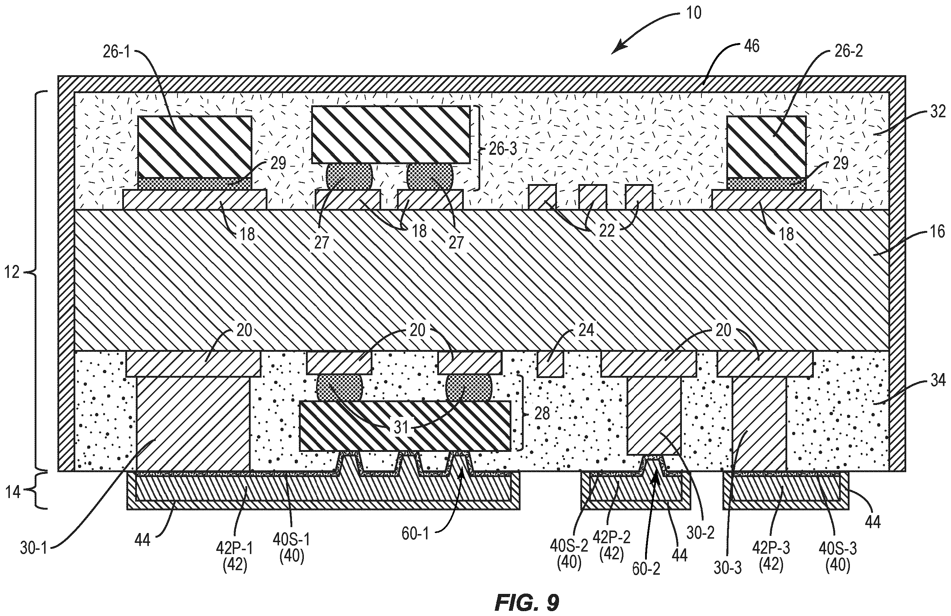

In some embodiments, the copper posts 30 may have different heights and the bottom component 28 might be shorter than certain ones of the copper posts 30. As such, the backside surface of the bottom component 28 and/or the end surface of one or more copper posts 30 may not be exposed at the bottom surface of the double-sided module 12, as illustrated in Figure 9. For the purpose of this illustration, the bottom component 28 and the second copper post 30-2 are shorter than the first and third copper post 30-1 and 30-3. The bottom surface of the bottom mold compound 34 extends vertically beyond the backside surface of the bottom component 28 and vertically beyond the end surface of the second copper post 30-2, while the end surfaces of the first copper post 30-1, the third copper post 30-3, and the bottom surface of the bottom mold compound 34 still constitute the bottom surface of the double-sided module 12.

Herein, the bottom mold compound 34 has a number of mold compound holes 60: three first mold compound holes 60-1 (for clarity, only one first mold compound hole is labeled with a reference number) are confined within the backside surface of the bottom component 28 and each extends from the bottom surface of the bottom mold compound 34 (i.e., the bottom surface of the double-sided module 12) to the backside surface of the bottom component 28, and one second mold compound hole 60-2 is confined within the end surface of the second copper post 30-2 and extends from the bottom surface of the bottom mold compound 34 (i.e., the bottom surface of double-sided module 12) to the bottom surface of the second copper post 30-2. As such, the backside surface of the bottom component 28 and the end surface of the second copper post 30-2 are partially exposed through the mold compound holes 60. In different applications, there might be fewer or more bottom components 28 and/or fewer or more copper posts 30 not exposed at the bottom surface of the double-sided module 12. In addition, the bottom mold compound 34 may include fewer or more mold compound holes 60 to partially expose the backside surface of the bottom component 28 and/or the end surface of one or more copper posts 30. The bottom flip-chip die 28 may be a gallium arsenide (GaAs) die, a Si die, a gallium nitride (GaN) die, or other.

Herein, the redistribution structure 14 in the multilevel SIP module 10 includes the seed layer 40 and the redistribution layer 42 without a dielectric pattern. The seed layer 40 completely and directly covers exposed surfaces within each mold compound hole 60, so as to be in contact with the backside surface of the bottom component 28 and the end surface of the second copper post 30-2. In addition, the seed layer 40 is in contact with and covers the end surfaces of the first copper post 30-1 and the third copper post 30-3, as well as portions of the bottom surface of the bottom mold compound 34. In particular, the seed layer 40 includes three discrete segments 40S. The first seed layer segment 40S-1 covers the bottom surface of the first copper post 30-1, surfaces within all first mold compound holes 60-1 confined within the bottom component 28, as well as portions of the bottom surface of the bottom mold compound 34 surrounding the bottom component 28 and the first copper post 30-1. The second seed layer segment 40S-2 covers surfaces within the second compound holes 60-2 confined within the second copper post 30-2 and portions of the bottom surface of the bottom mold compound 34 adjacent to the second copper post 30-2. The third seed layer segment 40S-3 covers the bottom surface of the third copper post 30-3 and portions of the bottom surface of the bottom mold compound 34 adjacent to the third copper post 30-3. The first seed layer segment 40S-1, the second seed layer segment 40S-2, and the third seed layer segment 40S-3 are separate from each other.

Each patterned conductive feature 42P is still in direct contact with a corresponding seed layer segment 40S. In this embodiment, the redistribution layer 42 includes three patterned conductive features 42P. The first patterned conductive feature 42P-1 is in direct contact with the first seed layer segment 40S-1, fills the first mold compound holes 60-1 confined within the bottom flip-chip die 28, and is electrically and/or thermally coupled to the bottom flip-chip die 28 and the first copper post 30-1. The second patterned conductive feature 42P-2 is in direct contact with the second seed layer segment 40S-2, fills the second mold compound hole 60-2 confined within the second copper post 30-2, and is electrically and/or thermally coupled to the second copper post 30-2. The third patterned conductive feature 42P-3 is in direct contact with the third seed layer segment 40S-3 and is electrically and/or thermally coupled to the third copper post 30-3.

In some applications, the seed layer 40 might be omitted, such that the redistribution layer 42 might be in direct contact with the backside surface of the bottom flip-chip die 28 and the end surface of the second copper post 30-2 through the mold compound holes 60, and in direct contact with the end surfaces of the first and third copper posts 30-1 and 30-3. In some applications, the redistribution layer 42 may include fewer or more patterned conductive features 42P with different coverages, and the seed layer 40 may include fewer or more discrete seed layer segments 40S corresponding to the discrete patterned conductive features 42P. In addition, the redistribution structure 14 may further include the coating 44 that completely covers each patterned conductive feature 42P and is configured to enable each patterned conductive feature 42P to have a solderable surface. The coating 44 may be formed of ENIG, OSP, ENEPIG, solder alloy, or other materials as long as they may preserve solderability of the patterned conductive features 42P.

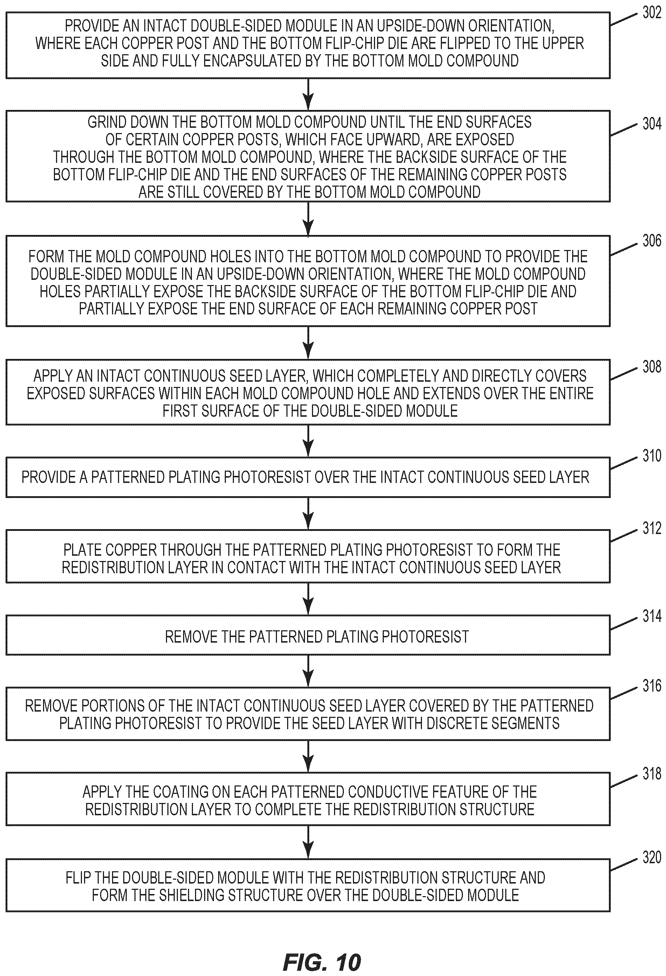

Figure 10 provides a flow diagram that illustrates an example process for fabricating the redistribution structure 14 of the multilevel SIP module 10 shown in Figure 9 according to some embodiments of the present disclosure. Although the flow diagram and the associated steps are illustrated in a series, they are not necessarily order dependent. Some steps may be done in a different order than that presented. Further, processes within the scope of this disclosure may include fewer or more steps than those illustrated in Figure 10.

Initially, an intact double-sided module is provided in an upside-down orientation (step 302). Herein, the intact double-sided module is similar to the double-sided module 12 except that in the intact double-sided module, each copper post 30 and the bottom flip-chip die 28 are fully encapsulated by the bottom mold compound 34. Due to the upside-down orientation, each copper post 30, the bottom flip-chip die 28, and the bottom mold compound 34 are flipped to the upper side of the intact double-sided module. For the sake of clarity, a first surface and a second surface (opposite the first surface) are respectively used to represent a bottom surface and a top surface of the intact double-sided module in the original orientation (i.e., in an orientation that each copper post 30, the bottom flip-chip die 28, and the bottom mold compound 34 are located at the lower side of the intact double-sided module).

Next, the bottom mold compound 34 is ground down until the end surfaces of certain copper posts 30 (e.g., the end surfaces of the first copper post 30-1 and the third copper post 30-3), which face upward, are exposed through the bottom mold compound 34 (step 304). After the grinding step, the backside surface of the bottom flip-chip die 28 and the end surfaces of the remaining copper posts 30 (e.g., the end surfaces of the second copper post 30-2) are still covered by the bottom mold compound 34. The mold compound holes 60 are then formed into the bottom mold compound 34 to provide the double-sided module 12 in an upside-down orientation (step 306). For the sake of clarity, a first surface and a second surface (opposite the first surface) are respectively used to represent the bottom surface and the top surface of the double-sided module 12 in the original orientation (as shown in Figure 9). The mold compound holes 60 are formed at positions to partially expose the backside surface of the bottom flip-chip die 28 (e.g., the first mold compound holes 60-1 partially expose the backside surface of the bottom flip-chip die 28) and partially expose the end surface of each remaining copper post 30 (e.g. the second mold compound hole 60-2 partially exposes the end surface of the second copper post 30-2). Each mold compound hole 60 is confined within the backside surface of the bottom flip-chip die 28 or one end surface of a corresponding copper post 30 (e.g., the second copper post 30-2). The mold compound holes 60 may be formed by laser drilling.

An intact continuous seed layer is applied to completely and directly cover exposed surfaces within each mold compound hole 60 and the entire first surface of the double-sided module 12 (step 308). A patterned plating photoresist is then provided over the intact continuous seed layer (step 310). First portions of the intact continuous seed layer are covered by the patterned plating photoresist, while second portions of the intact continuous seed layer are exposed through the patterned plating photoresist (i.e., the second portions of the intact continuous seed layer are the discrete seed layer segments 40S of the seed layer 40 in the final product). Herein, each mold compound hole 60, the end surface of the first copper post 30-1, and the end surface of the third copper post 30-3 are not covered by the patterned plating photoresist. Next, copper is plated through the patterned plating photoresist to form the redistribution layer 42 with the discrete patterned conductive features 42P (step 312). Herein, the intact continuous seed layer (especially the second portions of the intact continuous seed layer) is the plating base for the patterned conductive features 42P. Each patterned conductive feature 42P covers and is in contact with a corresponding second portion of the intact continuous seed layer.

After the redistribution layer 42 is formed, the patterned plating photoresist is removed (step 314), and the first portions of the intact continuous seed layer covered by the patterned plating photoresist are also removed (step 316). The first portions of the intact continuous seed layer might be removed by an etching process. The second portions of the intact continuous seed layer, which are covered by the patterned conductive features 42P, respectively (i.e., not covered by the patterned plating photoresist), are retained and become the discrete seed layer segments 40S that constitute the seed layer 40. The coating 44 is then applied to each patterned conductive feature 42P of the redistribution layer 42 to complete the redistribution structure 14 (step 318). The coating 44 completely covers each patterned conductive feature 42P and is configured to enable each patterned conductive feature 42P to have a solderable surface. The coating 44 may be formed of ENIG, OSP, ENEPIG, solder alloy, or other materials as long as they may preserve solderability of the patterned conductive features 42P.

Lastly, the double-sided module 12 with the redistribution structure 14 is flipped upside-down back to its original orientation, and the shielding structure 46 is formed over the double-sided module 12 to provide the multilevel SIP module 10 (step 320). Herein, the redistribution structure 14 is located underneath the double-sided module 12 at the first surface of the double-sided module 12, and the second surface of the double-sided module 12 faces upwards. The shielding structure 46 completely covers the second (top) surface of the double-sided module 12 and completely covers the side surfaces of the double-sided module 12 but does not cover the first (bottom) surface of the double-sided module 12, where the redistribution structure 14 is located.

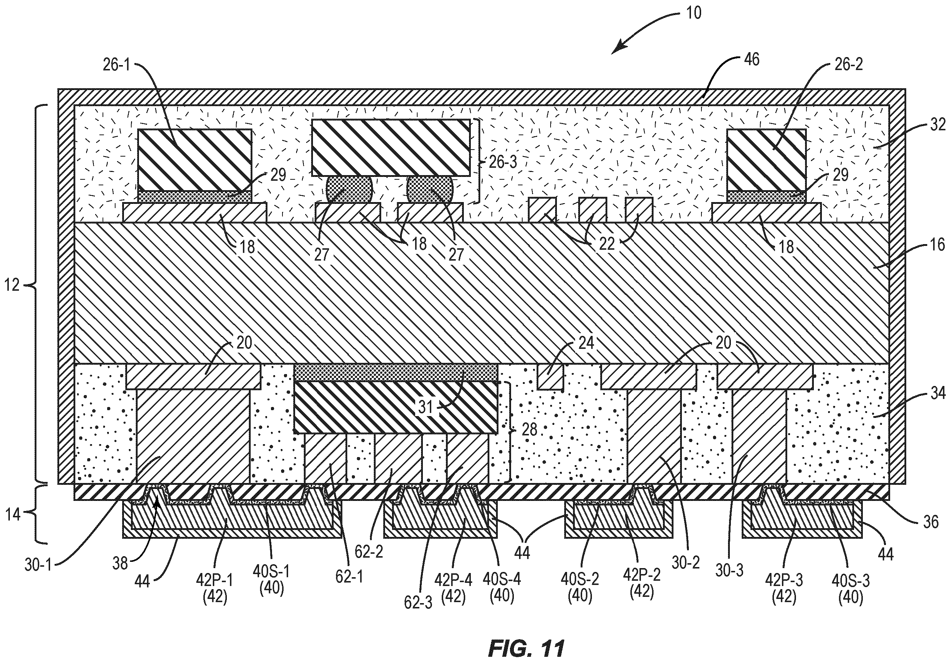

In some embodiments, the one or more bottom components 28 may be a flip-chip die with die copper pillars 62 as illustrated in Figure 11. For the purpose of this illustration, the bottom flip-chip die 28 includes three die copper pillars 62: a first die copper pillar 62-1, a second die copper pillar 62-2, and a third die copper pillar 62-3. In different applications, the double-sided module 12 may include more bottom flip-chip dies 28 with the die copper pillars 62, and the bottom flip-chip die 28 may include fewer or more die copper pillars 62. Herein, the backside surface of the bottom flip-chip die 28 is not exposed at the bottom of the double-sided module 12. Instead, the backside surface of the bottom flip-chip die 28 is attached to the bottom surface of the laminate body 16 with a bottom adhesive material 64, while a tip surface of each die copper pillar 62 is exposed at the bottom of the double-sided module 12 (i.e., the tip surface of each die copper pillar 62 is not covered by the bottom mold compound 34). Herein and hereafter, a tip surface of one die copper pillar refers to a surface of the die copper pillar away from the active region of the flip-chip die. The bottom surface of the double-sided module 12 is a combination of the bottom surface of the bottom mold compound 34, the tip surface of each die copper pillar 62, and the end surface of each copper post 30. With such posture configuration, the bottom flip-chip die 28 may be a GaAs die, a Si die, a GaN die, or other, but does include the die copper pillars 62 as interconnects.

The redistribution structure 14 underneath the double-sided module 12 includes the first dielectric pattern 36 with the first openings 38, the seed layer 40, and the redistribution layer 42. The first dielectric pattern 36 is located directly underneath the bottom surface of the double-sided module 12, such that the first dielectric pattern 36 is in contact with the bottom surface of the bottom mold compound 34, the end surface of each copper post 30, and the tip surface of each die copper pillar 62 of the bottom flip-chip die 28. The first openings 38 are positioned so that the end surface of each copper post 30 and the tip surface of each die copper pillar 62 can be partially exposed. For the purpose of this illustration, there are two first openings 38 confined within the end surface of the first copper post 30-1, one first opening 38 confined within each die copper pillar 62, one first opening 38 confined within the end surface of the second copper post 30-2, and one first opening 38 confined within the end surface of the third copper post 30-3. In different applications, there might be fewer or more first openings 38 to partially expose the end surface of each copper post 30 and the tip surface of each die copper pillar 62.

The seed layer 40 completely and directly covers exposed surfaces within each first opening 38 and extends underneath portions of the first dielectric pattern 36. As shown in this illustration, the seed layer 40 includes four discrete segments 40S. The first seed layer segment 40S-1 covers all first openings 38 confined within the first copper post 30-1 and the first die copper pillar 62-1 of the bottom flip-chip die 28, as well as portions of the first dielectric pattern 36 between and adjacent to these first openings 38. The second seed layer segment 40S-2 covers the first opening 38 confined within the second copper post 30-2, as well as portions of the first dielectric pattern 36 adjacent to the corresponding first opening 38. The third seed layer segment 40S-3 covers the first opening 38 confined within the third copper post 30-3, as well as portions of the first dielectric pattern 36 adjacent to the corresponding first opening 38. A fourth seed layer segment 40S-4 covers both first openings 38 confined within the second die copper pillar 62-2 and the third die copper pillar 62-3 of the bottom flip-chip die 28, as well as portions of the first dielectric pattern 36 between and adjacent to these two first openings 38. The first seed layer segment 40S-1, the second seed layer segment 40S-2, the third seed layer segment 40S-3, and the fourth seed layer segment 40S-4 are separate from each other.

Each patterned conductive feature 42P is in direct contact with a corresponding seed layer segment 40S, which is a deposition/plating base for the patterned conductive feature 42P (more details are described below). As such, each patterned conductive feature 42P fills one or more corresponding first openings 38 and extends underneath the first dielectric pattern 36. In this embodiment, the redistribution layer 42 includes four patterned conductive features 42P. The first patterned conductive feature 42P-1 is in direct contact with the first seed layer segment 40S-1, fills the first openings 38 confined within the first copper post 30-1 and the first die copper pillar 62-1 of the bottom flip-chip die 28, and is electrically and/or thermally coupled to the first die copper pillar 62-1 of the bottom flip-chip die 28 and the first copper post 30-1. The second patterned conductive feature 42P-2 is in direct contact with the second seed layer segment 40S-2, fills the first opening 38 confined within the second copper post 30-2, and is electrically and/or thermally coupled to the second copper post 30-2. The third patterned conductive feature 42P-3 is in direct contact with the third seed layer segment 40S-3, fills the first opening 38 confined within the third copper post 30-3, and is electrically and/or thermally coupled to the third copper post 30-3. A fourth patterned conductive feature 42P-4 is in direct contact with the fourth seed layer segment 40S-4, fills the first openings 38 confined within the second die copper pillar 62-2 and the third die copper pillar 62-3 of the bottom flip-chip die 28, and is electrically and/or thermally coupled to the second die copper pillar 62-2 and the third die copper pillar 62-3 of the bottom flip-chip die 28.

In some applications, the seed layer 40 might be omitted, such that the redistribution layer 42 might be in direct contact with the end surface of each copper post 30 and the tip surface of each die copper pillar 62 of the bottom flip-chip die 28 (not shown) and still fills each first opening 38. In some applications, the redistribution layer 42 may include fewer or more patterned conductive features 42P with different coverages, and the seed layer 40 may include fewer or more discrete seed layer segments 40S corresponding to the discrete patterned conductive features 42P. In addition, the redistribution structure 14 may further include the coating 44 that completely covers each patterned conductive feature 42P and is configured to enable each patterned conductive feature 42P to have a solderable surface. The coating 44 may be formed of ENIG, OSP, ENEPIG, solder alloy, or other materials as long as they may preserve solderability of the patterned conductive features 42P.

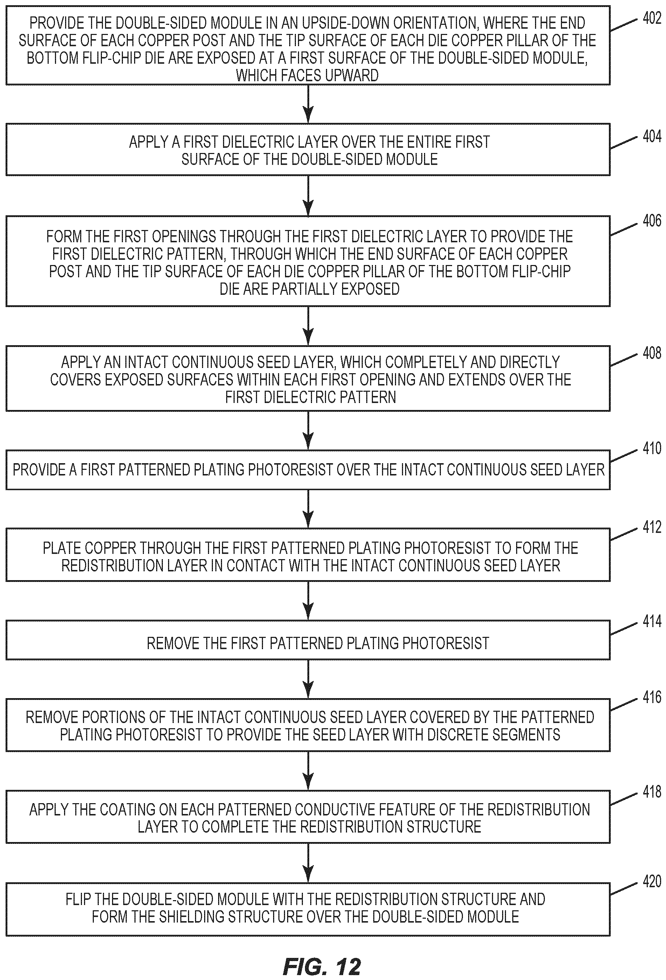

Figure 12 provides a flow diagram that illustrates an example process for fabricating the redistribution structure 14 of the multilevel SIP module 10 shown in Figure 11 according to some embodiments of the present disclosure. Although the flow diagram and the associated steps are illustrated in a series, they are not necessarily order dependent. Some steps may be done in a different order than that presented. Further, processes within the scope of this disclosure may include fewer or more steps than those illustrated in Figure 12.

Initially, the double-sided module 12 is provided in an upside-down orientation (step 402), such that the bottom surface and the top surface of the double-sided module 12 are swapped. Herein, for the sake of clarity, a first surface and a second surface (opposite the first surface) are respectively used to represent the bottom surface and the top surface of the double-sided module 12 in the original orientation (as shown in Figure 11). The bottom surface of each copper post 30 and the tip surface of each die copper pillar 62 of the bottom flip-chip die 28 are exposed at the first surface (i.e., the original bottom surface) of the double-sided module 12, which faces upward. The second surface (i.e., the original top surface) of the double-sided module 12 faces downward. Herein, a grinding process or a laser drilling process may be applied to expose the end surface of each copper post 30 and the tip surface of each die copper pillar 62 of the bottom flip-chip die 28.

Next, a first dielectric layer is applied over the entire first surface of the double-sided module 12 (step 404). The first dielectric layer may be a PID layer or a non-photo-imageable film (such as a build-up film). The first openings 38 are then formed through the first dielectric layer to provide the first dielectric pattern 36 (step 406). The first openings 38 are formed at positions so that the end surface of each copper post 30 and the tip surface of each die copper pillar 62 of the bottom flip-chip die 28 can be partially exposed. Each first opening 38 is confined within one end surface of a corresponding copper post 30 or one tip surface of a corresponding die copper pillar 62 of the bottom flip-chip die 28. The first openings 38 may be formed by laser drill photo-imaging (for the PID layer), which does not require a protective mask, or a laser ablation (for the non-photo-imageable film).

An intact continuous seed layer is applied over the first dielectric pattern 36 and completely and directly covers exposed surfaces within each first opening 38 (step 408). A first patterned plating photoresist is then provided over the intact continuous seed layer (step 410). First portions of the intact continuous seed layer are covered by the first patterned plating photoresist, while second portions of the intact continuous seed layer are exposed through the first patterned plating photoresist (i.e., the second portions of the intact continuous seed layer are the discrete seed layer segments 40S of the seed layer 40 in the final product). Each first opening 38 is confined within the second portions of the intact continuous seed layer and is not covered by the first patterned plating photoresist. Next, copper is plated through the first patterned plating photoresist to form the redistribution layer 42 with the discrete patterned conductive features 42P (step 412). Herein, the intact continuous seed layer (especially the second portions of the intact continuous seed layer) is the plating base for the patterned conductive features 42P. Each patterned conductive feature 42P covers and is in contact with a corresponding second portion of the intact continuous seed layer and fills one or more corresponding first openings 38.

After the redistribution layer 42 is formed, the first patterned plating photoresist is removed (step 414), and the first portions of the intact continuous seed layer covered by the first patterned plating photoresist are also removed (step 416). The first portions of the intact continuous seed layer might be removed by an etching process. The second portions of the intact continuous seed layer, which are covered by the patterned conductive features 42P, respectively (i.e., not covered by the first patterned plating photoresist), are retained and become the discrete seed layer segments 40S that constitute the seed layer 40. The coating 44 is then applied to each patterned conductive feature 42P of the redistribution layer 42 to complete the redistribution structure 14 (step 418). The coating 44 completely covers each patterned conductive feature 42P and is configured to enable each patterned conductive feature 42P to have a solderable surface. The coating 44 may be formed of ENIG, OSP, ENEPIG, solder alloy, or other materials as long as they may preserve solderability of the patterned conductive features 42P.

Lastly, the double-sided module 12 with the redistribution structure 14 is flipped upside-down back to its original orientation, and the shielding structure 46 is formed over the double-sided module 12 to provide the multilevel SIP module 10 (step 420). Herein, the redistribution structure 14 is located underneath the double-sided module 12 at the first surface of the double-sided module 12, and the second surface of the double-sided module 12 faces upwards. The shielding structure 46 completely covers the second (top) surface of the double-sided module 12 and completely covers the side surfaces of the double-sided module 12 but does not cover the first (bottom) surface of the double-sided module 12, where the redistribution structure 14 is located.

Regardless of the configuration, the redistribution structure 14 enables metallization underneath the bottom component 28, so as to provide an extra heat dissipation path for the bottom component 28. In addition, the redistribution structure 14 is eligible to accommodate a large metal feature to implement a ground plane and/or an inductive/matching element. With multi-level configurations (e.g., one or two levels of the dielectric patterns and two levels of the patterned conductive features as shown in Figures 3 and 7), the redistribution structure 14 may also provide a uniform connection pitch (with a consistent feature size) to a higher-level assembly. Furthermore, the redistribution structure 14 encapsulates the bottom surface of the double-sided module 12, so as to provide protection from environment, handling, and test, which will improve the overall reliability of the multilevel SIP module 10. In different applications, the redistribution structure 14 may include more levels of dielectric patterns and more levels of patterned conductive features with different combinations shown in Figures 1, 3, 5, 7, 9, and 11.

According to aspects disclosed herein, multilevel SIP modules and methods for providing enough connection and uniform I/Os and enhancing thermal and electrical performance, may be provided in or integrated into any processor-based electronics. Examples, without limitation, include a base station, a military application device, a settop box, an entertainment unit, a navigation device, a communications device, a fixed location data unit, a mobile location data unit, a global positioning system (GPS) device, a mobile phone, a cellular phone, a smartphone, a session initiation protocol (SIP) phone, a tablet, a phablet, a server, a computer, a portable computer, a mobile computing device, a wearable computing device (e.g., a smartwatch, a health or fitness tracker, eyewear, etc.), a desktop computer, a personal digital assistant (PDA), a monitor, a computer monitor, a television, a tuner, a radio, a satellite radio, a music player, a digital music player, a portable music player, a digital video player, a video player, a digital video disc (DVD) player, a portable digital video player, an automobile, a vehicle component, avionics systems, a drone, and a multicopter.

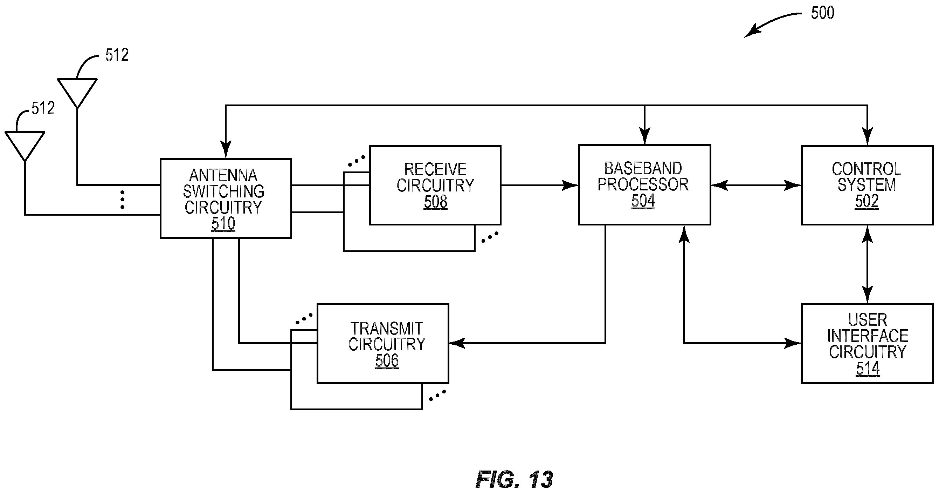

With reference to Figure 13, the concepts described above may be implemented in various types of communication devices 500, such as those listed in the previous paragraph. The communication device 500 will generally include a control system 502, a baseband processor 504, transmit circuitry 506, receive circuitry 508, antenna switching circuitry 510, multiple antennas 512, and user interface circuitry 514. Herein, at least one or any combination of the control system 502, the baseband processor 504, the transmit circuitry 506, and the receive circuitry 508 may be implemented in the multilevel SIP module 10 (e.g. implemented in the one or more top components 26 and/or one or more bottom components 28) as shown in Figures 1, 3, 5, 7, 9, and 11 and described above.

In a non-limiting example, the control system 502 can be a fieldprogrammable gate array (FPGA) or an application-specific integrated circuit (ASIC), as an example. In this regard, the control system 502 can include at least a microprocessor(s), an embedded memory circuit(s), and a communication bus interface(s). The receive circuitry 508 receives radio frequency signals via the antennas 512 and through the antenna switching circuitry 510 from one or more base stations. A low noise amplifier and a filter of the receive circuitry 508 cooperate to amplify and remove broadband interference from the received signal for processing. Down conversion and digitization circuitry (not shown) will then down convert the filtered, received signal to an intermediate or baseband frequency signal, which is then digitized into one or more digital streams using an analog-to-digital converter(s) (ADC).

The baseband processor 504 processes the digitized received signal to extract the information or data bits conveyed in the received signal. This processing typically comprises demodulation, decoding, and error correction operations, as will be discussed in greater detail below. The baseband processor 504 is generally implemented in one or more digital signal processors (DSPs) and ASICs.

For transmission, the baseband processor 504 receives digitized data, which may represent voice, data, or control information, from the control system 502, which it encodes for transmission. The encoded data is output to the transmit circuitry 506, where a digital-to-analog converter(s) (DAC) converts the digitally encoded data into an analog signal and a modulator modulates the analog signal onto a carrier signal that is at a desired transmit frequency or frequencies. A power amplifier will amplify the modulated carrier signal to a level appropriate for transmission and deliver the modulated carrier signal to the antennas 512 through the antenna switching circuitry 510. The multiple antennas 512 and the replicated transmit and receive circuitries 506, 508 may provide spatial diversity. Modulation and processing details will be understood by those skilled in the art.

Therefore, from one perspective, there has been described a multilevel system-in-package (SIP) module having a double-sided module and a redistribution structure located underneath the double-sided module. The double-sided module includes a laminate body, a top component attached to a top surface of the laminate body, a bottom component and multiple copper posts attached to a bottom surface of the laminate body, and a bottom mold compound formed on the bottom surface of the laminate body and at least encapsulating side surfaces of the bottom component and side surfaces of each copper post. A bottom surface of the bottom mold compound is a portion of a bottom surface of the double-sided module. The redistribution structure includes a redistribution layer with multiple patterned conductive features, which are separate from each other. Each patterned conductive feature is coupled to at least one of the bottom component and the copper posts.

Further examples of feature combinations taught by the present disclosure are set out in the following numbered clauses.

Clause 1. A multilevel system-in-package, SIP, module comprising: a double-sided module including a laminate body, at least one top component, a top mold compound, a bottom component, a plurality of copper posts, and a bottom mold compound, wherein: the at least one top component is attached to a top surface of the laminate body, and the top mold compound is formed on the top surface of the laminate body to encapsulate the at least one top component; the bottom component and the plurality of copper posts are attached to a bottom surface of the laminate body; and the bottom mold compound, which is formed on the bottom surface of the laminate body, at least encapsulates side surfaces of the bottom component and side surfaces of each of the plurality of copper posts; and a top surface of the double-sided module is a top surface of the top mold compound, side surfaces of the double-sided module are a combination of side surfaces of the top mold compound, side surfaces of the laminate body, and the side surfaces of the bottom mold compound, and a bottom surface of the double-sided module is at least composed of a bottom surface of the bottom mold compound; and a redistribution structure located underneath the bottom surface of the double-sided module, wherein: the redistribution structure includes a redistribution layer with a plurality of patterned conductive features, which are separate from each other; and each of the plurality of patterned conductive features is coupled to at least one of the bottom component and the plurality of copper posts.

Clause 2. The multilevel SIP module of clause 1, wherein: the bottom component is a flip-chip die; each of the plurality of copper posts has a same height; and the bottom surface of the bottom mold compound, a backside surface of the flip-chip die, and an end surface of each of the plurality of copper posts are coplanar and constitute the bottom surface of the double-sided module.

Clause 3. The multilevel SIP module of clause 2 wherein the flip-chip die is a silicon (Si) die.

Clause 4. The multilevel SIP module of clause 2 or 3 wherein: the redistribution structure further includes a first dielectric pattern with a plurality of first openings; the first dielectric pattern is located directly underneath the bottom surface of the double-sided module, such that the first dielectric pattern is in contact with the backside surface of the flip-chip die, and the end surface of each of the plurality of copper posts; the plurality of first openings is positioned so that the backside surface of the flip-chip die and the end surface of each of the plurality of copper posts are partially exposed; and the plurality of patterned conductive features fills the plurality of first openings to be coupled with the bottom component and the plurality of copper posts, respectively, and extends underneath the first dielectric pattern.

Clause 5. The multilevel SIP module of clause 4 wherein the first dielectric pattern is formed from a photo-imageable dielectric, PID, layer.

Clause 6. The multilevel SIP module of clause 4 wherein the first dielectric pattern is formed from a non-photo-imageable build-up film.

Clause 7. The multilevel SIP module of clause 4, 5 or 6 wherein: the redistribution structure further includes a seed layer with a plurality of discrete seed layer segments; the seed layer completely and directly covers exposed surfaces within each of the plurality of first openings and extends underneath portions of the first dielectric pattern, such that the seed layer is in contact with the backside surface of the flip-chip die, and the end surface of each of the plurality of copper posts; and each of the plurality of patterned conductive features is in direct contact with a corresponding one of the plurality of discrete seed layer segments, such that each of the plurality of patterned conductive features is coupled to at least one of the bottom component and the plurality of copper posts via the corresponding one of the plurality of discrete seed layer segments.

Clause 8. The multilevel SIP module of any of clauses 4 to 7 wherein: the redistribution structure further includes a plurality of extra patterned conductive features and a second dielectric pattern with a plurality of second openings; the second dielectric pattern is located directly underneath the first dielectric pattern to partially encapsulate each of the plurality of patterned conductive features, wherein each of the plurality of patterned conductive features is partially exposed through one or more corresponding ones of the plurality of second openings of the second dielectric pattern; and the plurality of extra patterned conductive features fills the plurality of second openings to be coupled with the plurality of patterned conductive features, respectively, and extends underneath the second dielectric pattern.

Clause 9. The multilevel SIP module of clause 8 wherein the second dielectric pattern is formed from a PID layer.

Clause 10. The multilevel SIP module of clause 8 wherein the second dielectric pattern is formed from a non-photo-imageable build-up film.

Clause 11. The multilevel SIP module of clause 8, 9 or 10 wherein: the redistribution structure further includes an extra seed layer with a plurality of discrete extra seed layer segments; the extra seed layer completely and directly covers exposed surfaces within each of the plurality of second openings and extends underneath portions of the second dielectric pattern, such that the extra seed layer is in contact with each of the plurality of patterned conductive features; and each of the plurality of extra patterned conductive features is in direct contact with a corresponding one of the plurality of discrete extra seed layer segments, such that the plurality of extra patterned conductive features is coupled to the plurality of patterned conductive features via corresponding ones of the plurality of discrete extra seed layer segments, respectively.

Clause 12. The multilevel SIP module of any of clauses 8 to 11 wherein the redistribution structure further includes a coating that completely covers each of the plurality of extra patterned conductive features and is configured to enable each of the plurality of extra patterned conductive features to have a solderable surface, wherein the coating is formed of one of electroless nickel immersion gold (ENIG), organic solderability preservatives (OSP), Electroless Nickel Electroless Palladium Immersion Gold (ENEPIG), and solder alloy.

Clause 13. The multilevel SIP module of any of clauses 2 to 12 wherein: the redistribution structure further includes a seed layer with a plurality of discrete seed layer segments; the seed layer is in contact with and partially covers the bottom surface of the double-sided module so as to be in contact with the backside surface of the flip-chip die, and the end surface of each of the plurality of copper posts; and each of the plurality of patterned conductive features is in direct contact with a corresponding one of the plurality of discrete seed layer segments, such that each of the plurality of patterned conductive features is coupled to at least one of the bottom component and the plurality of copper posts via the corresponding one of the plurality of discrete seed layer segments.

Clause 14. The multilevel SIP module of clause 13 wherein: the redistribution structure further includes a plurality of extra patterned conductive features and a dielectric pattern with a plurality of openings; the dielectric pattern is located directly underneath the bottom surface of the double-sided module to partially encapsulate each of the plurality of patterned conductive features, wherein each of the plurality of patterned conductive features is partially exposed through one or more corresponding ones of the plurality of openings of the dielectric pattern; and the plurality of extra patterned conductive features fills the plurality of openings to be coupled with the plurality of patterned conductive features, respectively, and extends underneath the dielectric pattern.

Clause 15. The multilevel SIP module of clause 14 wherein the dielectric pattern is formed from a PID layer.

Clause 16. The multilevel SIP module of clause 14 wherein the dielectric pattern is formed from a non-photo-imageable build-up film.

Clause 17. The multilevel SIP module of any of clauses 14 to 16 wherein: the redistribution structure further includes an extra seed layer with a plurality of discrete extra seed layer segments; the extra seed layer completely and directly covers exposed surfaces within each of the plurality of openings and extends underneath portions of the dielectric pattern, such that the extra seed layer is in contact with each of the plurality of patterned conductive features; and each of the plurality of extra patterned conductive features is in direct contact with a corresponding one of the plurality of discrete extra seed layer segments, such that the plurality of extra patterned conductive features is coupled to the plurality of patterned conductive features via corresponding ones of the plurality of discrete extra seed layer segments, respectively.

Clause 18. The multilevel SIP module of any of clauses 14 to 17 wherein the redistribution structure further includes a coating that completely covers each of the plurality of extra patterned conductive features and is configured to enable each of the plurality of extra patterned conductive features to have a solderable surface, wherein the coating is formed of one of ENIG, OSP, ENEPIG, and solder alloy.

Clause 19. The multilevel SIP module of any preceding clause, wherein: the bottom surface of the bottom mold compound extends vertically beyond a backside surface of the flip-chip die and is coplanar with an end surface of at least one of the plurality of copper posts; and the bottom mold compound has a plurality of mold compound holes, wherein at least one of the plurality of mold compound holes is confined within the backside surface of the flip-chip die and extends from the bottom surface of the bottom mold compound to the backside surface of the flip-chip die to partially expose the backside surface of the flip-chip die.

Clause 20. The multilevel SIP module of clause 19 wherein the flip-chip die is one of gallium arsenide (GaAs) die, a Si die, and a gallium nitride (GaN) die.

Clause 21. The multilevel SIP module of clause 19 or 20 wherein: the redistribution structure further includes a seed layer with a plurality of discrete seed layer segments; the seed layer is in contact with and partially covers the bottom surface of the double-sided module and completely and directly covers exposed surfaces within each of the plurality of mold compound holes, such that the seed layer is in contact with the backside surface of the flip-chip die and the end surface of the at least one of the plurality of copper posts; and the plurality of patterned conductive features is in direct contact with the plurality of discrete seed layer segments, respectively, and fills the plurality of mold compound holes.

Clause 22. The multilevel SIP module of clause 19, 20 or 21 wherein: the plurality of copper posts has different heights, wherein certain ones of the plurality of copper posts have a first height and remaining ones of the plurality of copper posts have a second height taller than the first height; the bottom surface of the bottom mold compound extends vertically beyond an end surface of each of the certain ones of the plurality of copper posts, and is coplanar with an end surface of each of the remaining ones of the plurality of copper posts, wherein the at least one of the plurality of copper posts is included in the remaining ones of the plurality of copper posts; and certain ones of the plurality of mold compound holes are confined within the end surfaces of the certain ones of the plurality of copper posts, respectively, and extend from the bottom surface of the bottom mold compound to the end surfaces of the certain ones of the plurality of copper posts, respectively, to partially expose each of the certain ones of the plurality of copper posts.

Clause 23. The multilevel SIP module of clause 22 wherein: the redistribution structure further includes a seed layer with a plurality of discrete seed layer segments; the seed layer is in contact with and partially covers the bottom surface of the double-sided module and completely and directly covers exposed surfaces within each of the plurality of mold compound holes, such that the seed layer is in contact with the backside surface of the flip-chip die and the end surface of each of the plurality of copper posts; and the plurality of patterned conductive features is in direct contact with the plurality of discrete seed layer segments, respectively, and fills the plurality of mold compound holes.

Clause 24. The multilevel SIP module of any preceding clause wherein: the bottom component is a flip-chip die with a plurality of die copper pillars, wherein a backside surface of the flip-chip die is attached to the bottom surface of the laminate body, and the plurality of die copper pillars extends toward the bottom surface of the double-sided module; each of the plurality of copper posts has a same height and is attached to the bottom surface of the laminate body; and the bottom surface of the bottom mold compound, a tip surface of each of the plurality of die copper pillars of the flip-chip die, and an end surface of each of the plurality of copper posts are coplanar and constitute the bottom surface of the double-sided module.

Clause 25. The multilevel SIP module of clause 24 wherein the flip-chip die is one of a GaAs die, a Si die, and a GaN die.

Clause 26. The multilevel SIP module of clause 24 or 25 wherein: the redistribution structure further includes a first dielectric pattern with a plurality of first openings; the first dielectric pattern is located directly underneath the bottom surface of the double-sided module, such that the first dielectric pattern is in contact with the tip surface of each of the plurality of die copper pillars of the flip-chip die, and the end surface of each of the plurality of copper posts; the plurality of first openings is positioned so that the tip surface of each of the plurality of die copper pillars and the end surface of each of the plurality of copper posts are partially exposed; and the plurality of patterned conductive features fills the plurality of first openings to be coupled with the plurality of copper posts and the plurality of die copper pillars of the bottom component, respectively, and extends underneath the first dielectric pattern.

Clause 27. The multilevel SIP module of clause 26 wherein the first dielectric pattern is formed from a PID layer.

Clause 28. The multilevel SIP module of clause 26 wherein the first dielectric pattern is formed from a non-photo-imageable build-up film.

Clause 29. The multilevel SIP module of clause 26, 27 or 28 wherein: the redistribution structure further includes a seed layer with a plurality of discrete seed layer segments; the seed layer completely and directly covers exposed surfaces within each of the plurality of first openings and extends underneath portions of the first dielectric pattern, such that the seed layer is in contact with the tip surface of each of the plurality of die copper pillars and the end surface of each of the plurality of copper posts; and each of the plurality of patterned conductive features is in direct contact with a corresponding one of the plurality of discrete seed layer segments, such that each of the plurality of patterned conductive features is coupled to at least one of the bottom component and the plurality of copper posts via the corresponding one of the plurality of discrete seed layer segments.

Clause 30. The multilevel SIP module of any preceding clause further comprising a shielding structure, which completely covers the top surface of the double-sided module and completely covers the side surfaces of the double-sided module but does not cover the bottom surface of the double-sided module, where the redistribution structure is located.

Clause 31. The multilevel SIP module of any preceding clause wherein the at least one top component is one of a flip-chip die, a wire-bonding die, a surface mounted device (SMD), a filter, a Si device, a power amplifier (PA), and a passive component.

Clause 32. The multilevel SIP module of any preceding clause wherein the bottom component is one of a flip-chip die, a SMD, a filter, a Si device, a PA, and a passive component.

Clause 33. The multilevel SIP module of any preceding clause wherein the redistribution structure further includes a coating that completely covers each of the plurality of patterned conductive features and is configured to enable each of the plurality of patterned conductive features to have a solderable surface, wherein the coating is formed of one of ENIG, OSP, ENEPIG, and solder alloy.

Clause 34. The multilevel SIP module of any preceding clause wherein the redistribution layer is formed of copper.

Clause 35. The multilevel SIP module of any preceding clause wherein the redistribution layer is configured to provide at least one of a heat dissipation path for the bottom component, a ground plane, an inductive element, and a connection pitch change of the multilevel SIP module.

Clause 36. The multilevel SIP module of any preceding clause wherein each of the plurality of patterned conductive features is one of a metal pad, a metal trace, and a metal via.

Clause 37. A communication device comprising: a control system; a baseband processor; receive circuitry; and transmit circuitry, wherein at least one or any combination of the control system, the baseband processor, the transmit circuitry, and the receive circuitry is implemented in a multilevel SIP module, which includes a double-sided module and a redistribution structure located underneath a bottom surface of the double-sided module, wherein: the double-sided module includes a laminate body, at least one top component, a top mold compound, a bottom component, a plurality of copper posts, and a bottom mold compound; the at least one top component is attached to a top surface of the laminate body, and the top mold compound is formed on the top surface of the laminate body to encapsulate the at least one top component; the bottom component and the plurality of copper posts are attached to a bottom surface of the laminate body, while the bottom mold compound, which is formed on the bottom surface of the laminate body, at least encapsulates side surfaces of the bottom component and side surfaces of each of the plurality of copper posts; a top surface of the double-sided module is a top surface of the top mold compound, side surfaces of the double-sided module are a combination of side surfaces of the top mold compound, side surfaces of the laminate body, and the side surfaces of the bottom mold compound, and a bottom surface of the double-sided module is at least composed of a bottom surface of the bottom mold compound; the redistribution structure includes a redistribution layer with a plurality of patterned conductive features, which are separate from each other; and each of the plurality of patterned conductive features is coupled to at least one of the bottom component and the plurality of copper posts.

Clause 38. A method comprising: providing a double-sided module including a laminate body, at least one top component, a top mold compound, a bottom component, a plurality of copper posts, and a bottom mold compound, wherein: the at least one top component is attached to a top surface of the laminate body, and the top mold compound is formed on the top surface of the laminate body to encapsulate the at least one top component; the bottom component and the plurality of copper posts are attached to a bottom surface of the laminate body, while the bottom mold compound, which is formed on the bottom surface of the laminate body, at least encapsulates side surfaces of the bottom component and side surfaces of each of the plurality of copper posts; and a top surface of the double-sided module is a top surface of the top mold compound, side surfaces of the double-sided module are a combination of side surfaces of the top mold compound, side surfaces of the laminate body, and the side surfaces of the bottom mold compound, and a bottom surface of the double-sided module is at least composed of a bottom surface of the bottom mold compound; and forming a redistribution structure, which is located underneath the bottom surface of the double-sided module, wherein: the redistribution structure includes a redistribution layer with a plurality of patterned conductive features, which are separate from each other; and each of the plurality of patterned conductive features is coupled to at least one of the bottom component and the plurality of copper posts.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

## Claims

1. A multilevel system-in-package, SIP, module comprising:
• a double-sided module including a laminate body, at least one top component, a top mold compound, a bottom component, a plurality of copper posts, and a bottom mold compound, wherein:
• the at least one top component is attached to a top surface of the laminate body, and the top mold compound is formed on the top surface of the laminate body to encapsulate the at least one top component;
• the bottom component and the plurality of copper posts are attached to a bottom surface of the laminate body; and
• the bottom mold compound, which is formed on the bottom surface of the laminate body, at least encapsulates side surfaces of the bottom component and side surfaces of each of the plurality of copper posts; and
• a top surface of the double-sided module is a top surface of the top mold compound, side surfaces of the double-sided module are a combination of side surfaces of the top mold compound, side surfaces of the laminate body, and the side surfaces of the bottom mold compound, and a bottom surface of the double-sided module is at least composed of a bottom surface of the bottom mold compound; and
• a redistribution structure located underneath the bottom surface of the double-sided module, wherein:
• the redistribution structure includes a redistribution layer with a plurality of patterned conductive features, which are separate from each other; and
• each of the plurality of patterned conductive features is coupled to at least one of the bottom component and the plurality of copper posts.

2. The multilevel SIP module of claim 1, wherein:
• the bottom component is a flip-chip die, for example a silicon, Si, die;
• each of the plurality of copper posts has a same height; and
• the bottom surface of the bottom mold compound, a backside surface of the flip-chip die, and an end surface of each of the plurality of copper posts are coplanar and constitute the bottom surface of the double-sided module.

3. The multilevel SIP module of claim 2 wherein:
• the redistribution structure further includes a first dielectric pattern with a plurality of first openings;
• the first dielectric pattern is located directly underneath the bottom surface of the double-sided module, such that the first dielectric pattern is in contact with the backside surface of the flip-chip die, and the end surface of each of the plurality of copper posts;
• the plurality of first openings is positioned so that the backside surface of the flip-chip die and the end surface of each of the plurality of copper posts are partially exposed; and
• the plurality of patterned conductive features fills the plurality of first openings to be coupled with the bottom component and the plurality of copper posts, respectively, and extends underneath the first dielectric pattern.

4. The multilevel SIP module of claim 3 wherein:
• the redistribution structure further includes a seed layer with a plurality of discrete seed layer segments;
• the seed layer completely and directly covers exposed surfaces within each of the plurality of first openings and extends underneath portions of the first dielectric pattern, such that the seed layer is in contact with the backside surface of the flip-chip die, and the end surface of each of the plurality of copper posts; and
• each of the plurality of patterned conductive features is in direct contact with a corresponding one of the plurality of discrete seed layer segments, such that each of the plurality of patterned conductive features is coupled to at least one of the bottom component and the plurality of copper posts via the corresponding one of the plurality of discrete seed layer segments.

5. The multilevel SIP module of claim 3 or 4 wherein:
• the redistribution structure further includes a plurality of extra patterned conductive features and a second dielectric pattern with a plurality of second openings;
• the second dielectric pattern is located directly underneath the first dielectric pattern to partially encapsulate each of the plurality of patterned conductive features, wherein each of the plurality of patterned conductive features is partially exposed through one or more corresponding ones of the plurality of second openings of the second dielectric pattern; and
• the plurality of extra patterned conductive features fills the plurality of second openings to be coupled with the plurality of patterned conductive features, respectively, and extends underneath the second dielectric pattern.

6. The multilevel SIP module of claim 5 wherein:
• the redistribution structure further includes an extra seed layer with a plurality of discrete extra seed layer segments;
• the extra seed layer completely and directly covers exposed surfaces within each of the plurality of second openings and extends underneath portions of the second dielectric pattern, such that the extra seed layer is in contact with each of the plurality of patterned conductive features; and
• each of the plurality of extra patterned conductive features is in direct contact with a corresponding one of the plurality of discrete extra seed layer segments, such that the plurality of extra patterned conductive features is coupled to the plurality of patterned conductive features via corresponding ones of the plurality of discrete extra seed layer segments, respectively.

7. The multilevel SIP module of claim 5 or 6 wherein the redistribution structure further includes a coating that completely covers each of the plurality of extra patterned conductive features and is configured to enable each of the plurality of extra patterned conductive features to have a solderable surface, wherein the coating is formed of one of electroless nickel immersion gold (ENIG), organic solderability preservatives (OSP), Electroless Nickel Electroless Palladium Immersion Gold (ENEPIG), and solder alloy.

8. The multilevel SIP module of claim 2 wherein:
• the redistribution structure further includes a seed layer with a plurality of discrete seed layer segments;
• the seed layer is in contact with and partially covers the bottom surface of the double-sided module so as to be in contact with the backside surface of the flip-chip die, and the end surface of each of the plurality of copper posts; and
• each of the plurality of patterned conductive features is in direct contact with a corresponding one of the plurality of discrete seed layer segments, such that each of the plurality of patterned conductive features is coupled to at least one of the bottom component and the plurality of copper posts via the corresponding one of the plurality of discrete seed layer segments.

9. The multilevel SIP module of claim 8 wherein:
• the redistribution structure further includes a plurality of extra patterned conductive features and a dielectric pattern with a plurality of openings;
• the dielectric pattern is located directly underneath the bottom surface of the double-sided module to partially encapsulate each of the plurality of patterned conductive features, wherein each of the plurality of patterned conductive features is partially exposed through one or more corresponding ones of the plurality of openings of the dielectric pattern; and
• the plurality of extra patterned conductive features fills the plurality of openings to be coupled with the plurality of patterned conductive features, respectively, and extends underneath the dielectric pattern.

10. The multilevel SIP module of claim 9 wherein:
• the redistribution structure further includes an extra seed layer with a plurality of discrete extra seed layer segments;
• the extra seed layer completely and directly covers exposed surfaces within each of the plurality of openings and extends underneath portions of the dielectric pattern, such that the extra seed layer is in contact with each of the plurality of patterned conductive features; and
• each of the plurality of extra patterned conductive features is in direct contact with a corresponding one of the plurality of discrete extra seed layer segments, such that the plurality of extra patterned conductive features is coupled to the plurality of patterned conductive features via corresponding ones of the plurality of discrete extra seed layer segments, respectively.

11. The multilevel SIP module of claim 9 or 10 wherein the redistribution structure further includes a coating that completely covers each of the plurality of extra patterned conductive features and is configured to enable each of the plurality of extra patterned conductive features to have a solderable surface, wherein the coating is formed of one of ENIG, OSP, ENEPIG, and solder alloy.

12. The multilevel SIP module of claim 1, wherein:
• the bottom surface of the bottom mold compound extends vertically beyond a backside surface of the flip-chip die and is coplanar with an end surface of at least one of the plurality of copper posts; and
• the bottom mold compound has a plurality of mold compound holes, wherein at least one of the plurality of mold compound holes is confined within the backside surface of the flip-chip die and extends from the bottom surface of the bottom mold compound to the backside surface of the flip-chip die to partially expose the backside surface of the flip-chip die.

13. The multilevel SIP module of claim 12 wherein:
• the redistribution structure further includes a seed layer with a plurality of discrete seed layer segments;
• the seed layer is in contact with and partially covers the bottom surface of the double-sided module and completely and directly covers exposed surfaces within each of the plurality of mold compound holes, such that the seed layer is in contact with the backside surface of the flip-chip die and the end surface of the at least one of the plurality of copper posts; and
• the plurality of patterned conductive features is in direct contact with the plurality of discrete seed layer segments, respectively, and fills the plurality of mold compound holes.

14. The multilevel SIP module of claim 12 or 13 wherein:
• the plurality of copper posts has different heights, wherein certain ones of the plurality of copper posts have a first height and remaining ones of the plurality of copper posts have a second height taller than the first height;
• the bottom surface of the bottom mold compound extends vertically beyond an end surface of each of the certain ones of the plurality of copper posts, and is coplanar with an end surface of each of the remaining ones of the plurality of copper posts, wherein the at least one of the plurality of copper posts is included in the remaining ones of the plurality of copper posts; and
• certain ones of the plurality of mold compound holes are confined within the end surfaces of the certain ones of the plurality of copper posts, respectively, and extend from the bottom surface of the bottom mold compound to the end surfaces of the certain ones of the plurality of copper posts, respectively, to partially expose each of the certain ones of the plurality of copper posts.

15. The multilevel SIP module of claim 14 wherein:
• the redistribution structure further includes a seed layer with a plurality of discrete seed layer segments;
• the seed layer is in contact with and partially covers the bottom surface of the double-sided module and completely and directly covers exposed surfaces within each of the plurality of mold compound holes, such that the seed layer is in contact with the backside surface of the flip-chip die and the end surface of each of the plurality of copper posts; and
• the plurality of patterned conductive features is in direct contact with the plurality of discrete seed layer segments, respectively, and fills the plurality of mold compound holes.

16. The multilevel SIP module of claim 1 wherein:
• the bottom component is a flip-chip die with a plurality of die copper pillars, wherein a backside surface of the flip-chip die is attached to the bottom surface of the laminate body, and the plurality of die copper pillars extends toward the bottom surface of the double-sided module;
• each of the plurality of copper posts has a same height and is attached to the bottom surface of the laminate body; and
• the bottom surface of the bottom mold compound, a tip surface of each of the plurality of die copper pillars of the flip-chip die, and an end surface of each of the plurality of copper posts are coplanar and constitute the bottom surface of the double-sided module.

17. The multilevel SIP module of claim 16 wherein:
• the redistribution structure further includes a first dielectric pattern with a plurality of first openings;
• the first dielectric pattern is located directly underneath the bottom surface of the double-sided module, such that the first dielectric pattern is in contact with the tip surface of each of the plurality of die copper pillars of the flip-chip die, and the end surface of each of the plurality of copper posts;
• the plurality of first openings is positioned so that the tip surface of each of the plurality of die copper pillars and the end surface of each of the plurality of copper posts are partially exposed; and
• the plurality of patterned conductive features fills the plurality of first openings to be coupled with the plurality of copper posts and the plurality of die copper pillars of the bottom component, respectively, and extends underneath the first dielectric pattern.

18. The multilevel SIP module of claim 17 wherein:
• the redistribution structure further includes a seed layer with a plurality of discrete seed layer segments;
• the seed layer completely and directly covers exposed surfaces within each of the plurality of first openings and extends underneath portions of the first dielectric pattern, such that the seed layer is in contact with the tip surface of each of the plurality of die copper pillars and the end surface of each of the plurality of copper posts; and
• each of the plurality of patterned conductive features is in direct contact with a corresponding one of the plurality of discrete seed layer segments, such that each of the plurality of patterned conductive features is coupled to at least one of the bottom component and the plurality of copper posts via the corresponding one of the plurality of discrete seed layer segments.

19. The multilevel SIP module of any of claims 12 to 18 wherein the flip-chip die is one of a GaAs die, a Si die, and a GaN die.

20. The multilevel SIP module of any of claims 3 to 11 or 16 to 19 wherein the first dielectric pattern is formed from a photo-imageable dielectric, PID, layer.

21. The multilevel SIP module of any of claims 3 to 11 or 16 to 19 wherein the first dielectric pattern is formed from a non-photo-imageable build-up film.

22. The multilevel SIP module of any preceding claim further comprising a shielding structure, which completely covers the top surface of the double-sided module and completely covers the side surfaces of the double-sided module but does not cover the bottom surface of the double-sided module, where the redistribution structure is located.

23. The multilevel SIP module of any preceding claim wherein the at least one top component is one of a flip-chip die, a wire-bonding die, a surface mounted device (SMD), a filter, a Si device, a power amplifier (PA), and a passive component.

24. The multilevel SIP module of any preceding claim wherein the bottom component is one of a flip-chip die, a SMD, a filter, a Si device, a PA, and a passive component.

25. The multilevel SIP module of any preceding claim wherein the redistribution structure further includes a coating that completely covers each of the plurality of patterned conductive features and is configured to enable each of the plurality of patterned conductive features to have a solderable surface, wherein the coating is formed of one of ENIG, OSP, ENEPIG, and solder alloy.

26. The multilevel SIP module of any preceding claim wherein the redistribution layer is configured to provide at least one of a heat dissipation path for the bottom component, a ground plane, an inductive element, and a connection pitch change of the multilevel SIP module.

27. A communication device comprising:
• a control system;
• a baseband processor;
• receive circuitry; and
• transmit circuitry, wherein at least one or any combination of the control system, the baseband processer, the transmit circuitry, and the receive circuitry is implemented in the multilevel SIP module of any preceding claim.

28. A method comprising:
• providing a double-sided module including a laminate body, at least one top component, a top mold compound, a bottom component, a plurality of copper posts, and a bottom mold compound, wherein:
• the at least one top component is attached to a top surface of the laminate body, and the top mold compound is formed on the top surface of the laminate body to encapsulate the at least one top component;
• the bottom component and the plurality of copper posts are attached to a bottom surface of the laminate body, while the bottom mold compound, which is formed on the bottom surface of the laminate body, at least encapsulates side surfaces of the bottom component and side surfaces of each of the plurality of copper posts; and
• a top surface of the double-sided module is a top surface of the top mold compound, side surfaces of the double-sided module are a combination of side surfaces of the top mold compound, side surfaces of the laminate body, and the side surfaces of the bottom mold compound, and a bottom surface of the double-sided module is at least composed of a bottom surface of the bottom mold compound; and
• forming a redistribution structure, which is located underneath the bottom surface of the double-sided module, wherein:
• the redistribution structure includes a redistribution layer with a plurality of patterned conductive features, which are separate from each other; and
• each of the plurality of patterned conductive features is coupled to at least one of the bottom component and the plurality of copper posts.
